# EUROPEAN PATENT APPLICATION

(11) **EP 4 142 428 A1**
(43) Date of publication of application: **01.03.2023**
(21) Application number: 20935236.8
(22) Date of filing: 15.05.2020
(51) Int. Cl.: H04W 88/02

(54) **COMMUNICATION METHOD, DEVICE AND SYSTEM**

(71) Applicant: Huawei Technologies Co., Ltd., Shenzhen, Guangdong 518129 (CN)
(72) Inventor: GAO, Lei, Shenzhen, Guangdong 518129 (CN); CHENG, Xingqing, Shenzhen, Guangdong 518129 (CN); WANG, Jian, Shenzhen, Guangdong 518129 (CN)
(74) Representative: Pfenning, Meinig & Partner mbB
(86) International application number: PCT/CN2020/090680
(87) International publication number: WO 2021/227076

(57) **Abstract**

This application discloses a communications method, apparatus, and system, and is applicable to wireless communication fields such as the internet of vehicles, intelligent driving, assisted driving, and intelligent connected vehicles. The communications method may include: encoding first data according to a first coding scheme; sending the encoded first data; encoding second data according to a second coding scheme, where the first data is different from the second data, and the second coding scheme is different from the first coding scheme; and sending the encoded second data.

## Description

### TECHNICAL FIELD

This application relates to the field of wireless communication technologies, and in particular, to a communications method, apparatus, and system.

### BACKGROUND

Compared with a conventional mobile broadband (mobile broadband, MBB) service such as video transmission, new services based on wireless communication in the future such as augmented reality (augmented reality, AR)/virtual reality (virtual reality, VR), the internet of vehicles, telemedicine, industrial control, and power transmission communication have higher requirements for a transmission latency and transmission reliability.

A vehicle-to-everything (vehicle-to-everything, V2X) communications manner is used as an example. Diversified in-vehicle applications increase a quantity of in-vehicle communications nodes and types of the in-vehicle communications nodes, and impose a higher requirement on an in-vehicle communication capability. Compared with existing wired communication, wireless communication between vehicle-mounted devices can further reduce a quantity of in-vehicle cable harnesses, lengths and weight of the in-vehicle cable harnesses, and corresponding installation and maintenance costs. Currently, how to support data transmission of different services in wireless communication still needs to be studied.

### SUMMARY

This application provides a communications method, apparatus, and system, to improve transmission performance of data of different services, and meet requirements of the different services.

According to a first aspect, this application provides a communications method, including: encoding first data according to a first coding scheme; sending the encoded first data; encoding second data according to a second coding scheme, where the first data is different from the second data, and the second coding scheme is different from the first coding scheme; and sending the encoded second data.

The method may be performed by a first communications apparatus, and the first communications apparatus is a transmit end apparatus. The first communications apparatus may be a communications device, or a communications apparatus, for example, a chip, that can support a communications device in implementing a function required in the method. For example, when the communications method is applied to a vehicle, the first communications apparatus may be a vehicle-mounted device, or a chip that is disposed in a vehicle-mounted device and that is configured to implement a function of the vehicle-mounted device, or another component configured to implement a function of a vehicle-mounted device. Alternatively, the first communications apparatus may be a terminal device, or a chip that is disposed in a terminal device and that is configured to implement a function of the terminal device, or another component configured to implement a function of a terminal device.

In this embodiment of this application, the second coding scheme is set to be different from the first coding scheme, so that different data may be encoded according to different coding schemes. To be specific, the first data is encoded according to the first coding scheme, and the second data is coded according to the second coding scheme. Therefore, different service requirements corresponding to different data can be better adapted, and transmission performance of data of different services can be improved.

In a possible implementation, the first coding scheme is a Reed-Solomon (reed-solomon, RS) coding scheme. The first data is encoded according to the RS coding scheme. That is, RS encoding is performed on the first data.

According to the foregoing method, when the first data has a high latency requirement, a coding scheme of the first data may be selected as the RS coding scheme. Compared with a coding scheme commonly used in wireless communication, the RS coding scheme has a shorter encoding latency, and can meet a requirement of a service for an extremely low latency. In addition, the RS coding scheme further has a capability of detecting error data. Whether an error occurs in currently received data can be directly determined according to the RS coding scheme, to avoid extra overheads generated in a coding scheme in the conventional technology in which another check mode (for example, cyclic redundancy check (cyclic redundancy check, CRC)) is required to determine whether an error occurs in data.

In a possible implementation, the second coding scheme is a polar (polar) coding scheme. The first data is encoded according to the polar coding scheme. That is, polar encoding is performed on the first data.

According to the foregoing method, the first communications apparatus selects the polar (polar) coding scheme for the second data, and performance of the polar (polar) coding scheme is better than that of the RS coding scheme. To be specific, the polar coding scheme has higher coding complexity and higher reliability than the RS coding scheme at a same code rate. Alternatively, a selected coding scheme can achieve same reliability as the RS coding scheme, but has a higher code rate and corresponds to higher spectral efficiency, so that transmission performance of the second data can be improved, effective resource utilization can be improved, and link performance can be improved. For example, the coding scheme may be selected.

In a possible implementation, that the first data is different from the second data includes at least one of the following:
a service type of the second data is different from a service type of the first data;
a priority of the second data is different from a priority of the first data; and
a transmission mode of the first data is different from a transmission mode of the first data.

According to the foregoing method, the first communications apparatus may determine the first coding scheme of the first data based on at least one of the service type, the priority, or the transmission mode of the first data. The first communications apparatus may determine the second coding scheme of the second data based on at least one of the service type, the priority, or the transmission mode of the second data. For example, service types may be classified according to a latency requirement of data, so that data of different service types can correspond to different coding schemes. Further, the first communications apparatus may determine, in different service scenarios, a coding scheme applicable to data, and encode the data according to the coding scheme, to improve applicability of the communications method.

In a possible implementation, the first data is noise reduction service data, or the first data contains noise reduction service data, or the first data includes noise reduction service data.

The noise reduction service data has a latency requirement different from other service data. Therefore, the first coding scheme may be set for the noise reduction service data, to distinguish the first coding scheme from the second coding scheme of the second data. This can better adapt to different service requirements corresponding to different data, improve effective utilization of resources, and improve link performance.

In a possible implementation, the second data is multimedia service data, or the second data contains multimedia service data, or the second data includes multimedia service data.

A data packet of the multimedia service data is large and a service volume accounts for a high proportion in a total service volume. Therefore, the second coding scheme may be set for this type of service data, to better adapt to different service requirements corresponding to different data, improve effective utilization of resources, and improve link performance.

In a possible implementation, the communications method is performed by a master node, and the method further includes:
sending scheduling signaling, where the scheduling signaling is used to determine at least one of the following:
a coding scheme of the first data is the first coding scheme; and
a coding scheme of the second data is the second coding scheme.

In the foregoing implementation, the first communications apparatus is a master node. Before sending the first data, the first communications apparatus may send the scheduling signaling to indicate, to a peer device, that the coding scheme of the first data is the first coding scheme, so as to ensure consistency of coding schemes used when the first communications apparatus and the peer device transmit the first data. Before sending the second data, the first communications apparatus may send the scheduling signaling to indicate, to the peer device, that the coding scheme of the second data is the second coding scheme, so as to ensure consistency of coding schemes used when the first communications apparatus and the peer device transmit the second data.

In a possible implementation, the communications method is performed by a master node, and the method further includes:
receiving transmission request signaling, where the transmission request signaling is used to determine at least one of the following:
the coding scheme of the first data is the first coding scheme; and
the coding scheme of the second data is the second coding scheme.

In the foregoing implementation, the first communications apparatus is a master node. Before sending the first data, the first communications apparatus may receive the transmission request signaling sent by a peer device. The transmission request signaling may be used to request the first communications apparatus to determine the coding scheme of the first data. Therefore, the first communications apparatus can determine, based on the transmission request signaling sent by the peer device, that the coding scheme of the first data is the first coding scheme. Before sending the second data, the first communications apparatus may receive the transmission request signaling sent by the peer device. The transmission request signaling may be used to request the first communications apparatus to determine the coding scheme of the second data. Therefore, the first communications apparatus can determine, based on the transmission request signaling sent by the peer device, that the coding scheme of the second data is the second coding scheme.

In a possible implementation, the communications method is performed by a slave node, and the method further includes:
receiving scheduling signaling, where the scheduling signaling is used to determine at least one of the following:
the coding scheme of the first data is the first coding scheme; and
the coding scheme of the second data is the second coding scheme.

In the foregoing implementation, the first communications apparatus is a slave node, the first communications apparatus may listen to scheduling by a master node, and the master node may be a master node that is located in a same communication domain as the first communications apparatus. In this case, the first communications apparatus determines, based on the received scheduling signaling from the master node, that the coding scheme of the first data is the first coding scheme, to ensure consistency of coding schemes used when the first communications apparatus and the peer device transmit the first data; and/or the first communications apparatus determines, based on the received scheduling signaling from the master node, that the coding scheme of the second data is the second coding scheme, to ensure consistency of coding schemes used when the first communications apparatus and the peer device transmit the second data.

In a possible implementation, the communications method is performed by a slave node, and the method further includes:
sending transmission request signaling, where the transmission request signaling is used to determine at least one of the following:
the coding scheme of the first data is the first coding scheme; and
the coding scheme of the second data is the second coding scheme.

In the foregoing implementation, the first communications apparatus is a slave node, the first communications apparatus may listen to scheduling by a master node, and the master node may be a master node that is located in a same communication domain as the first communications apparatus. In this case, the first communications apparatus may send the transmission request signaling to the master node, and the transmission request signaling may be used to request the master node to determine that the coding scheme of the first data is the first coding scheme, so that the master node schedules a coding scheme of the first data on the first communications apparatus after determining the coding scheme of the first data; and/or before sending the second data, the first communications apparatus may receive the transmission request signaling sent by the peer device, and the transmission request signaling may be used to request the first communications apparatus to determine that the coding scheme of the second data is the second coding scheme, so that the master node schedules the coding scheme of the second data on the first communications apparatus after determining the coding scheme of the second data.

In a possible implementation, the scheduling signaling includes a first field.

The first field is used to determine at least one of the following: the coding scheme of the first data or the coding scheme of the second data.

According to the foregoing method, when the first communications apparatus is a master node, the first communications apparatus may send the scheduling signaling by using the first field, to ensure consistency of coding schemes used when the first communications apparatus and the peer device transmit data, and improve transmission performance. When the first communications apparatus is a slave node, the scheduling signaling from the master node may be received by using the first field, to ensure consistency of coding schemes used when the first communications apparatus and the master node transmit data, and improve transmission performance.

In a possible implementation, the first field is used to indicate at least one of the following: the first coding scheme, the priority of the first data, the service type of the first data, or the transmission mode of the first data; and the second coding scheme, the priority of the second data, the service type of the second data, or the transmission mode of the second data.

According to the foregoing method, the first communications apparatus can adapt to different service scenarios, use the first field to carry corresponding content, and receive/send the scheduling signaling, to determine, based on the scheduling signaling, a coding scheme corresponding to data, ensure consistency of coding schemes used when the first communications apparatus and the peer device transmit data, and improve transmission performance.

In a possible implementation, the transmission request signaling includes a second field, and the second field is used to determine at least one of the following: the coding scheme of the first data or the coding scheme of the second data.

According to the foregoing method, when the first communications apparatus is a slave node, the transmission request signaling may be sent by using the second field, to request the master node to schedule a coding scheme (for example, the first coding scheme of the first data or the second coding scheme of the second data) corresponding to data, so as to ensure consistency of coding schemes used when the first communications apparatus and the peer device transmit data, and improve transmission performance. When the first communications apparatus is a master node, the first communications apparatus may receive the transmission request signaling from the slave node by using the second field, so that the first communications apparatus determines a coding scheme corresponding to data based on the scheduling request signaling, to ensure consistency of coding schemes used when the first communications apparatus and the slave node transmit data, and improve transmission performance.

In a possible implementation, the second field is used to indicate at least one of the following:
the first coding scheme, the priority of the first data, the service type of the first data, or the transmission mode of the first data; and the second coding scheme, the priority of the second data, the service type of the second data, or the transmission mode of the second data.

According to the foregoing method, the first communications apparatus can adapt to different service scenarios, and send/receive the scheduling request signaling by using the foregoing content indicated in the second field, so that the master node determines a coding scheme (for example, the first coding scheme of the first data or the second coding scheme of the second data) corresponding to data based on the scheduling request signaling, to ensure consistency of coding schemes used when the first communications apparatus and the peer device transmit data, and improve transmission performance.

In a possible implementation, the method further includes: determining a coding parameter of the RS coding based on a size of a data packet carrying the first data.

According to the foregoing method, the first communications apparatus may determine the coding parameter of the RS coding based on the size of the data packet carrying the first data. This simplifies a manner of determining the coding parameter of the RS coding scheme, and improves efficiency of processing the first data by the first communications apparatus.

In a possible implementation, the method further includes: sending or receiving control signaling, where a coding scheme of the control signaling is the first coding scheme, and the control signaling includes at least one of the following: physical layer signaling and higher layer signaling.

According to the foregoing method, the first communications apparatus may further receive/send the control signaling, and the coding scheme of the control signaling is the first coding scheme. Therefore, complexity of selecting a coding scheme by the first communications apparatus can be reduced, to control complexity of signaling transmission.

In a possible implementation, the coding scheme of the control signaling includes a parameter of the coding scheme of the control signaling, and the parameter of the coding scheme of the control signaling is determined based on at least one of the following: a size, a format, or a type of the control signaling.

According to the foregoing method, the first communications apparatus may determine the coding parameter of the control signaling based on the size, the format, or the type of the control signaling, to simplify a manner of determining the coding parameter of the coding scheme of the control signaling, and improve efficiency of processing the control signaling by the first communications apparatus.

According to a second aspect, this application provides a communications method. The method includes: receiving data; and decoding the data according to a first coding scheme, where the first coding scheme is one of at least two coding schemes.

The method may be performed by a second communications apparatus, and the second communications apparatus is a receive end apparatus. The second communications apparatus may be a communications device, or a communications apparatus, for example, a chip, that can support a communications device in implementing a function required in the method. For example, when the communications method is applied to a vehicle, the second communications apparatus may be a vehicle-mounted device, or a chip that is disposed in a vehicle-mounted device and that is configured to implement a function of the vehicle-mounted device, or another component configured to implement a function of a vehicle-mounted device. Alternatively, the second communications apparatus may be a terminal device, or a chip that is disposed in a terminal device and that is configured to implement a function of the terminal device, or another component configured to implement a function of a terminal device.

In this embodiment of this application, a plurality of coding schemes are set, so that the second communications apparatus can receive the data according to one of the plurality of coding schemes, to better adapt to different service requirements corresponding to different data, and improve transmission performance of data of different services.

In a possible implementation, the first coding scheme is an RS coding scheme.

In a possible implementation, the method further includes: decoding the data according to a second coding scheme, where the second coding scheme is different from the first coding scheme.

In the foregoing method, the second communications apparatus flexibly selects a decoding scheme in different application scenarios. For example, the second communications apparatus may decode the received data through blind detection according to the first coding scheme and the second coding scheme. For example, the first coding scheme may be randomly selected from a plurality of coding schemes to decode the received data, and when the decoding fails, the second coding scheme is selected to decode the data until the decoding succeeds. Alternatively, it may be determined, through scheduling, that a current coding scheme corresponding to the data is the second coding scheme, to decode the data according to the second coding scheme. Alternatively, it is determined, through scheduling, that a current coding scheme corresponding to the data is the first coding scheme, to decode the data according to the first coding scheme.

In a possible implementation, the second coding scheme is a polar coding scheme.

In a possible implementation, the communications method is performed by a master node. The method further includes: sending scheduling signaling, where the scheduling signaling is used to determine that a coding scheme of the data is the first coding scheme or a coding scheme of the data is the second coding scheme; and decoding the data according to the coding scheme that is of the data and that is determined based on the scheduling signaling.

According to the foregoing method, the second communications apparatus is a master node. Before receiving the first data, the second communications apparatus may send the scheduling signaling, to indicate a peer device to send a coding scheme of the data, to ensure consistency of coding schemes used when the second communications apparatus and the peer device transmit the data.

In a possible implementation, the data is noise reduction service data or multimedia service data; or the data contains at least one of the following: noise reduction service data or multimedia service data; or the data includes at least one of the following: noise reduction service data or multimedia service data.

In a possible implementation, the communications method is performed by a master node. The method further includes: receiving transmission request signaling, where the transmission request signaling is used to determine that the coding scheme of the data is the first coding scheme or the coding scheme of the data is the second coding scheme.

In the foregoing implementation, the second communications apparatus is a master node. Before receiving the data, the second communications apparatus may receive the transmission request signaling sent by a peer device. The transmission request signaling may be used to request the second communications apparatus to determine the coding scheme of the first data. Therefore, the second communications apparatus can determine the coding scheme of the data based on the transmission request signaling sent by the peer device.

In a possible implementation, the communications method is performed by a slave node. The method further includes: receiving scheduling signaling, where the scheduling signaling is used to determine that the coding scheme of the data is the first coding scheme or the coding scheme of the data is the second coding scheme; and decoding the data according to the coding scheme that is of the data and that is determined based on the scheduling signaling.

In the foregoing implementation, the second communications apparatus is a slave node, the second communications apparatus may listen to scheduling by a master node, and the master node may be a master node that is located in a same communication domain as the second communications apparatus. In this case, the second communications apparatus determines the coding scheme of the data based on the received scheduling signaling from the master node, to ensure consistency of coding schemes used when the second communications apparatus and the peer device transmit the data.

In a possible implementation, the communications method is performed by a slave node. The method further includes: sending transmission request signaling, where the transmission request signaling is used to determine that the coding scheme of the data is the first coding scheme or the coding scheme of the data is the second coding scheme.

In the foregoing implementation, the second communications apparatus is a slave node, the second communications apparatus may listen to scheduling by a master node, and the master node may be a master node that is located in a same communication domain as the second communications apparatus. In this case, the second communications apparatus may send the transmission request signaling to the master node, and the transmission request signaling may be used to request the master node to determine the coding scheme of the data, so that the master node schedules a coding scheme of the data on the second communications apparatus after determining the coding scheme of the data.

In a possible implementation, the scheduling signaling includes a first field, and the first field is used to determine that the coding scheme of the data is the first coding scheme or the coding scheme of the data is the second coding scheme.

In a possible implementation, the transmission request signaling includes a second field, and the second field is used to determine the coding scheme of the data, or that the coding scheme of the data is the second coding scheme.

According to the foregoing method, when the second communications apparatus is a master node, the second communications apparatus may send the scheduling signaling by using the first field, to ensure consistency of coding schemes used when the second communications apparatus and the peer device transmit data, and improve transmission performance. When the second communications apparatus is a slave node, the scheduling signaling from the master node may be received by using the first field, to ensure consistency of coding schemes used when the second communications apparatus and the master node transmit data, and improve transmission performance.

In a possible implementation, the first field is used to indicate at least one of the following: the coding scheme of the data, a priority of the data, a service type of the data, or a transmission mode of the data; or
the second field is used to indicate at least one of the following: the coding scheme of the data, a priority of the data, a service type of the data, or a transmission mode of the data.

According to the foregoing method, the second communications apparatus can adapt to different service scenarios, use the first field to carry corresponding content, and receive/send the scheduling signaling, to determine, based on the scheduling signaling, the coding scheme corresponding to the data, ensure consistency of coding schemes used when the second communications apparatus and the peer device transmit data, and improve transmission performance. Alternatively, the second communications apparatus receives/sends the transmission request signaling by using the second field, to request the master node to determine the coding scheme corresponding to the data.

In a possible implementation, the method further includes: determining a coding parameter of the first coding scheme based on a size of a data packet carrying the data.

According to the foregoing method, the second communications apparatus may determine the coding parameter of the first coding scheme based on the size of the data packet carrying the data. This simplifies a manner of determining the coding parameter of the first coding scheme, and improves efficiency of processing the data by the second communications apparatus.

In a possible implementation, the method includes: sending or receiving control signaling, where a coding scheme of the control signaling is the first coding scheme, and the control signaling includes at least one of the following: physical layer signaling and higher layer signaling.

According to the foregoing method, the second communications apparatus may further receive/send the control signaling, and the coding scheme of the control signaling is the first coding scheme. Therefore, complexity of selecting a coding scheme by the first communications apparatus can be reduced, to control complexity of signaling transmission.

In a possible implementation, the coding scheme of the control signaling includes a parameter of the coding scheme of the control signaling, and the parameter of the coding scheme of the control signaling is determined based on at least one of the following: a size, a format, or a type of the control signaling.

According to the foregoing method, the second communications apparatus may determine the coding parameter of the control signaling based on the size, the format, or the type of the control signaling, to simplify a manner of determining the coding parameter of the coding scheme of the control signaling, and improve efficiency of processing the control signaling by the second communications apparatus.

For technical effects brought by the second aspect or some implementations of the second aspect, refer to the description of the technical effects of the first aspect or the corresponding implementations of the first aspect. Details are not described herein.

According to a third aspect, this application provides a communications apparatus. For example, the communications apparatus is the first communications apparatus described above. The first communications apparatus is configured to perform the method according to any one of the first aspect or the possible implementations. Specifically, the first communications apparatus may include modules configured to perform the method according to any one of the first aspect or the possible implementations, for example, include a processing module and a transceiver module.

For example, the transceiver module may include a sending module and a receiving module. The sending module and the receiving module may be different functional modules, or may be a same functional module, but can implement different functions (the sending module is configured to implement a signal sending function, and the receiving module is configured to implement a signal receiving function). For example, the first communications apparatus is a communications device, or is a chip or another component disposed in the communications device. For example, the communications device is a network device, a terminal device, or a vehicle-mounted device. For example, the first communications apparatus may be a vehicle-mounted device, or may be a chip or another component disposed in the vehicle-mounted device. For example, the transceiver module may alternatively be implemented as a transceiver, and the processing module may alternatively be implemented as a processor. Alternatively, the sending module may be implemented as a transmitter, and the receiving module may be implemented as a receiver. The transmitter and the receiver may be different functional modules, or may be a same functional module, but can implement different functions (the transmitter is configured to implement a signal sending function, and the receiver is configured to implement a signal receiving function). For example, if the first communications apparatus is the communications device, the transceiver is implemented by an antenna, a feeder, and a codec in the communications device. Alternatively, if the first communications apparatus is the chip disposed in the communications device, the transceiver (or the transmitter and the receiver) is, for example, a communications interface (or an interface circuit) in the chip, and the communications interface is connected to a radio frequency transceiver component in the communications device, to receive/send information through the radio frequency transceiver component. In a description process of the third aspect, the processing module and the transceiver module are still used as an example for description. For example, the communications apparatus is the first communications apparatus.

The processing module is configured to: encode first data according to a first coding scheme, and send the encoded first data through the transceiver module; and encode second data according to a second coding scheme, and send the encoded second data through the transceiver module, where the first data is different from the second data, and the second coding scheme is different from the first coding scheme.

In a possible implementation, the first coding scheme is an RS coding scheme.

In a possible implementation, the second coding scheme is a polar (polar) coding scheme.

In a possible implementation, that the first data is different from the second data includes at least one of the following:
a service type of the second data is different from a service type of the first data;
a priority of the second data is different from a priority of the first data; and
a transmission mode of the first data is different from a transmission mode of the first data.

In a possible implementation, the first data is noise reduction service data, or the first data contains noise reduction service data, or the first data includes noise reduction service data.

In a possible implementation, the second data is multimedia service data, or the second data contains multimedia service data, or the second data includes multimedia service data.

In a possible implementation, the communications apparatus is a master node. The processing module is further configured to send scheduling signaling through the transceiver module, where the scheduling signaling is used to determine at least one of the following: a coding scheme of the first data is the first coding scheme, and a coding scheme of the second data is the second coding scheme.

In a possible implementation, the communications apparatus is a master node. The processing module is further configured to receive transmission request signaling through the transceiver module, where the transmission request signaling is used to determine at least one of the following: the coding scheme of the first data is the first coding scheme, and the coding scheme of the second data is the second coding scheme.

In a possible implementation, the communications apparatus is a slave node. The processing module is further configured to receive scheduling signaling through the transceiver module, where the scheduling signaling is used to determine at least one of the following: the coding scheme of the first data is the first coding scheme, and the coding scheme of the second data is the second coding scheme.

In a possible implementation, the communications apparatus is a slave node. The processing module is further configured to send transmission request signaling through the transceiver module, where the transmission request signaling is used to determine at least one of the following: the coding scheme of the first data is the first coding scheme, and the coding scheme of the second data is the second coding scheme.

In a possible implementation, the scheduling signaling includes a first field, and the first field is used to determine at least one of the following: the coding scheme of the first data or the coding scheme of the second data.

In a possible implementation, the first field is used to indicate at least one of the following: the first coding scheme, the priority of the first data, the service type of the first data, or the transmission mode of the first data; and the second coding scheme, the priority of the second data, the service type of the second data, or the transmission mode of the second data.

In a possible implementation, the transmission request signaling includes a second field, and the second field is used to determine at least one of the following: the coding scheme of the first data or the coding scheme of the second data.

In a possible implementation, the second field is used to indicate at least one of the following: the first coding scheme, the priority of the first data, the service type of the first data, or the transmission mode of the first data; and the second coding scheme, the priority of the second data, the service type of the second data, or the transmission mode of the second data.

In a possible implementation, the processing module is further configured to determine a coding parameter of the RS coding based on a size of a data packet carrying the first data.

In a possible implementation, the processing module is further configured to send or receive control signaling through the transceiver module, where a coding scheme of the control signaling is the first coding scheme, and the control signaling includes at least one of the following: physical layer signaling and higher layer signaling.

In a possible implementation, the coding scheme of the control signaling includes a parameter of the coding scheme of the control signaling, and the parameter of the coding scheme of the control signaling is determined based on at least one of the following: a size, a format, or a type of the control signaling.

For technical effects brought by the optional implementations above, refer to the descriptions of the technical effects brought by the first aspect or the corresponding implementations.

According to a fourth aspect, a communications apparatus is provided. For example, the communications apparatus is the second communications apparatus described above. The second communications apparatus is configured to perform the method according to any one of the second aspect or the possible implementations. Specifically, the second communications apparatus may include modules configured to perform the method according to any one of the second aspect or the possible implementations, for example, include a processing module and a transceiver module. For example, the transceiver module may include a sending module and a receiving module. The sending module and the receiving module may be different functional modules, or may be a same functional module, but can implement different functions (the sending module is configured to implement a signal sending function, and the receiving module is configured to implement a signal receiving function). For example, the second communications apparatus is a communications device, or is a chip or another component disposed in the communications device. For example, the communications device is a network device (for example, an access network device), a terminal device, or a vehicle-mounted device. For example, the second communications apparatus may be a vehicle-mounted device, or may be a chip or another component disposed in the vehicle-mounted device. For example, the transceiver module may alternatively be implemented as a transceiver, and the processing module may alternatively be implemented as a processor. Alternatively, the sending module may be implemented as a transmitter, and the receiving module may be implemented as a receiver. The transmitter and the receiver may be different functional modules, or may be a same functional module, but can implement different functions (the transmitter is configured to implement a signal sending function, and the receiver is configured to implement a signal receiving function). For example, if the second communications apparatus is the communications device, the transceiver is implemented by an antenna, a feeder, and a codec in the communications device. Alternatively, if the second communications apparatus is the chip disposed in the communications device, the transceiver (or the transmitter and the receiver) is, for example, a communications interface (or an interface circuit) in the chip, and the communications interface is connected to a radio frequency transceiver component in the communications device, to receive/send information through the radio frequency transceiver component. In a description process of the fourth aspect, the processing module and the transceiver module are still used as an example for description. For example, the communications apparatus is the second communications apparatus. The processing module is configured to: receive data through the transceiver module; and decode the data according to a first coding scheme, where the first coding scheme is one of at least two coding schemes.

In a possible implementation, the first coding scheme is an RS coding scheme.

In a possible implementation, the second coding scheme is a polar coding scheme.

In a possible implementation, the processing module is configured to decode the data according to a second coding scheme, where the second coding scheme is different from the first coding scheme.

In a possible implementation, the data is noise reduction service data or multimedia service data; or the data contains at least one of the following: noise reduction service data or multimedia service data; or the data includes at least one of the following: noise reduction service data or multimedia service data.

In a possible implementation, the communications apparatus is a master node. The processing module is further configured to send scheduling signaling through the transceiver module; and decode the data according to a coding scheme that is of the data and that is determined based on the scheduling signaling. The scheduling signaling is used to determine that a coding scheme of the data is the first coding scheme or a coding scheme of the data is the second coding scheme.

In a possible implementation, the communications apparatus is a master node. The processing module is further configured to receive transmission request signaling through the transceiver module, where the transmission request signaling is used to determine that the coding scheme of the data is the first coding scheme or the coding scheme of the data is the second coding scheme.

In a possible implementation, the communications apparatus is a slave node. The processing module is further configured to: receive scheduling signaling through the transceiver module; and decode the data according to the coding scheme that is of the data and that is determined based on the scheduling signaling, where the scheduling signaling is used to determine that the coding scheme of the data is the first coding scheme or the coding scheme of the data is the second coding scheme; and decode the data according to the first coding scheme determined based on the scheduling signaling.

In a possible implementation, the communications apparatus is a slave node. The processing module is further configured to send transmission request signaling through the transceiver module, where the transmission request signaling is used to determine that the coding scheme of the data is the first coding scheme or the coding scheme of the data is the second coding scheme.

In a possible implementation, the scheduling signaling includes a first field, and the first field is used to determine that the coding scheme of the data is the first coding scheme or the coding scheme of the data is the second coding scheme.

In a possible implementation, the transmission request signaling includes a second field, and the second field is used to determine the coding scheme of the data, or that the coding scheme of the data is the second coding scheme.

In a possible implementation, the first field is used to indicate at least one of the following: the coding scheme of the data, a priority of the data, a service type of the data, or a transmission mode of the data; or
the second field is used to indicate at least one of the following: the coding scheme of the data, a priority of the data, a service type of the data, or a transmission mode of the data.

In a possible implementation, the processing module is further configured to determine a coding parameter of the first coding scheme based on a size of a data packet carrying the data.

In a possible implementation, the processing module is further configured to send or receive control signaling through the transceiver module, where a coding scheme of the control signaling is the first coding scheme, and the control signaling includes at least one of the following: physical layer signaling and higher layer signaling.

In a possible implementation, the coding scheme of the control signaling includes a parameter of the coding scheme of the control signaling, and the parameter of the coding scheme of the control signaling is determined based on at least one of the following: a size, a format, or a type of the control signaling.

For technical effects brought by the optional implementations above, refer to the descriptions of the technical effects brought by the second aspect or the corresponding implementations.

According to a fifth aspect, a communications apparatus is provided. The communications apparatus is, for example, the first communications apparatus described above. The communications apparatus includes a processor and a communications interface (or an interface circuit). The communications interface may be configured to communicate with another apparatus or device. Optionally, the communications apparatus may further include a memory, configured to store computer instructions. The processor and the memory are coupled to each other, to implement the method according to the first aspect or the possible implementations. Alternatively, the first communications apparatus may not include a memory, and the memory may be located outside the first communications apparatus. The processor, the memory, and the communications interface are coupled to each other, to implement the method according to the first aspect or the possible implementations. For example, when the processor executes the computer instructions stored in the memory, the first communications apparatus is enabled to perform the method according to any one of the first aspect or the possible implementations. For example, the first communications apparatus is a communications device, or is a chip or another component disposed in the communications device. For example, the communications device is a terminal device or a vehicle-mounted device. For example, the first communications apparatus may be a vehicle-mounted device, or may be a chip or another component disposed in the vehicle-mounted device.

If the first communications apparatus is the communications device, the communications interface is implemented, for example, as a transceiver (or a transmitter and a receiver) in the communications device, and the transceiver is implemented, for example, as an antenna, a feeder, and a codec in the communications device. Alternatively, if the first communications apparatus is the chip disposed in the communications device, the communications interface is, for example, an input/output interface such as an input/output pin in the chip. The communications interface is connected to a radio frequency transceiver component in the communications device, to receive/send information through the radio frequency transceiver component.

According to a sixth aspect, a communications apparatus is provided. The communications apparatus is, for example, the second communications apparatus described above. The communications apparatus includes a processor and a communications interface (or an interface circuit). The communications interface may be configured to communicate with another apparatus or device. Optionally, the communications apparatus may further include a memory, configured to store computer instructions. The processor and the memory are coupled to each other, to implement the method according to the second aspect or the possible implementations. Alternatively, the second communications apparatus may not include a memory, and the memory may be located outside the second communications apparatus. The processor, the memory, and the communications interface are coupled to each other, to implement the method according to the second aspect or the possible implementations. For example, when the processor executes the computer instructions stored in the memory, the second communications apparatus is enabled to perform the method according to any one of the second aspect or the possible implementations. For example, the second communications apparatus is a communications device, or is a chip or another component disposed in the communications device. For example, the communications device is a network device (for example, an access network device), a terminal device, or a vehicle-mounted device. For example, the second communications apparatus may be a vehicle-mounted device, or may be a chip or another component disposed in the vehicle-mounted device.

If the second communications apparatus is the communications device, the communications interface is implemented, for example, as a transceiver (or a transmitter and a receiver) in the communications device, and the transceiver is implemented, for example, as an antenna, a feeder, and a codec in the communications device. Alternatively, if the second communications apparatus is the chip disposed in the communications device, the communications interface is, for example, an input/output interface such as an input/output pin in the chip. The communications interface is connected to a radio frequency transceiver component in the communications device, to receive/send information through the radio frequency transceiver component.

According to a seventh aspect, a chip is provided. The chip includes a processor and a communications interface, and the processor is coupled to the communications interface, to implement the method according to any one of the first aspect or the optional implementations.

Optionally, the chip may further include a memory. For example, the processor may read and execute a software program stored in the memory, to implement the method according to any one of the first aspect or the optional implementations. Alternatively, the memory may not be included in the chip, but is located outside the chip. That is, the processor may read and execute a software program stored in an external memory, to implement the method according to any one of the first aspect or the optional implementations.

According to an eighth aspect, a chip is provided. The chip includes a processor and a communications interface, and the processor is coupled to the communications interface, to implement the method according to any one of the second aspect or the optional implementations.

Optionally, the chip may further include a memory. For example, the processor may read and execute a software program stored in the memory, to implement the method according to any one of the second aspect or the optional implementations. Alternatively, the memory may not be included in the chip, but is located outside the chip. That is, the processor may read and execute a software program stored in an external memory, to implement the method according to any one of the second aspect or the optional implementations.

According to a ninth aspect, a communications system is provided. The communications system includes the communications apparatus according to the third aspect, the communications apparatus according to the fifth aspect, or the communications apparatus according to the seventh aspect, and includes the communications apparatus according to the fourth aspect, the communications apparatus according to the sixth aspect, or the communications apparatus according to the eighth aspect.

According to a tenth aspect, a computer-readable storage medium is provided. The computer-readable storage medium is configured to store a computer program. When the computer program is run on a computer, the computer is enabled to perform the method according to any one of the first aspect or the possible implementations.

According to an eleventh aspect, a computer-readable storage medium is provided. The computer-readable storage medium is configured to store a computer program. When the computer program is run on a computer, the computer is enabled to perform the method according to any one of the second aspect or the possible implementations.

According to a twelfth aspect, a computer program product including instructions is provided. The computer program product is configured to store a computer program. When the computer program is run on a computer, the computer is enabled to perform the method according to any one of the first aspect or the possible implementations.

According to a thirteenth aspect, a computer program product including instructions is provided. The computer program product is configured to store a computer program. When the computer program is run on a computer, the computer is enabled to perform the method according to any one of the second aspect or the possible implementations.

### BRIEF DESCRIPTION OF DRAWINGS

FIG. 1a to FIG. 1c each are a schematic diagram of a network architecture of a communications system to which an embodiment of this application is applicable;
FIG. 2 is a schematic flowchart of a communications method according to an embodiment of this application;
FIG. 3a and FIG. 3b each are a schematic flowchart of a communications method according to an embodiment of this application;
FIG. 4a and FIG. 4b each are a schematic flowchart of a communications method according to an embodiment of this application;
FIG. 5 is a schematic flowchart of a communications method according to an embodiment of this application;
FIG. 6a and FIG. 6b each are a schematic flowchart of a communications method according to an embodiment of this application;
FIG. 7a and FIG. 7b each are a schematic flowchart of a communications method according to an embodiment of this application;
FIG. 8 is a schematic flowchart of a communications method according to an embodiment of this application;
FIG. 9 is a schematic flowchart of a communications method according to an embodiment of this application;
FIG. 10 is a schematic diagram of a structure of a communications apparatus according to an embodiment of this application;
FIG. 11 is a schematic diagram of a structure of a communications apparatus according to an embodiment of this application; and
FIG. 12 is a schematic diagram of a structure of a communications apparatus according to an embodiment of this application.

### DESCRIPTION OF EMBODIMENTS

The following describes in detail embodiments of this application with reference to accompanying drawings.

The following first explains some terms in this application to facilitate understanding by a person skilled in the art.
(1) Cockpit domain controller (cockpit domain controller or control domain cockpit, CDC): The CDC may also be referred to as a head unit. Functions of the head unit may include functions such as a radio, music video playing, and navigation in a cockpit, and may further include a cellular communication function (3G, 4G, and the like), to implement information communication between a person and a vehicle and between a vehicle and the outside, to enhance user experience and functions related to a service and security.
(2) Master node and slave node: Two types of communications apparatuses that have a communication function and that are distinguished in terms of logical functions are respectively referred to as a master node and a slave node. The master node may manage resources of a communication domain, and has a function of scheduling resources for a communication link between the master node and the slave node. The master node manages the slave node and has a resource allocation function for allocating resources for communication between the master node and the slave node. The slave node listens to scheduling by the master node and uses the resources allocated by the master node to communicate with the master node. The master node or the slave node may be various communications apparatuses. For example, the master node is a mobile phone, and the slave node is a headset. The mobile phone establishes a communication connection to the headset to exchange data. The mobile phone manages the headset. The mobile phone has a resource allocation function, and may allocate, to the headset, resources for communicating with the mobile phone.
(3) Communication domain: The communication domain is a system including a group of communications apparatuses that have a communication relationship and a communication connection relationship between the communications apparatuses. Usually, one communication domain includes one master node and at least one slave node, and the master node communicates with the slave node by using resources scheduled by the master node. One communications apparatus may belong to a plurality of communication domains. For example, when a mobile phone performs wireless communication with a headset, the mobile phone is in a communication domain a including the mobile phone and the headset. In the communication domain a, the mobile phone is a master node, the headset is a slave node, and resources scheduled by the mobile phone may be used for communication between the mobile phone and the headset. Then, after the mobile phone detects a CDC and establishes a wireless connection to the CDC, the mobile phone is also in a communication domain b including the mobile phone and the CDC. In the communication domain b, the CDC is a master node, the mobile phone is a slave node, and resources scheduled by the CDC may be used for communication between the CDC and the mobile phone. The communication domain b may further include other slave nodes such as a vehicle-mounted speaker and a vehicle-mounted microphone.
(4) Communication between master and slave nodes: The communication between the master and slave nodes includes transmission of signals, signaling, and service data between the master and slave nodes by using resources. The resources may include at least one type of time domain resources, frequency domain resources, or code domain resources. The signals include signals having one or more functions such as synchronization, channel estimation, channel sounding, phase tracking, positioning, and access. The signaling includes physical layer signaling and/or higher layer signaling. The transmission includes transmission (downlink transmission for short) in which the master node performs sending and the slave node performs receiving and transmission (uplink transmission for short) in which the slave node performs sending and the master node performs receiving. Based on a quantity of receive nodes and ranges of the receive nodes, transmission can be classified into unicast, multicast, and broadcast. The downlink transmission may be unicast, multicast, or broadcast. Downlink transmission in which a receive slave node is a specific slave node is unicast. Downlink transmission in which receive slave nodes are all slave nodes in a node group is multicast, where the slave node group includes at least one slave node. Downlink transmission in which receive slave nodes are all slave nodes in a communication domain is broadcast. Uplink transmission is necessarily unicast, because a receive node of uplink transmission is a master node, and there is only one master node in a communication domain.
(5) Reed-Solomon (reed-solomon, RS) coding: The RS coding is channel coding for forward error correction. Compared with common coding such as low-density parity-check (low-density parity-check, LDPC) coding and polar coding in wireless communication, the RS coding scheme has a shorter encoding latency and a shorter decoding latency, and can meet a requirement of a service for an extremely low latency. The RS coding scheme further has a capability of detecting error data. Whether an error occurs in currently received data can be directly determined according to the RS coding scheme, to avoid extra overheads (for example, CRC check bits) generated in a coding scheme in the conventional technology in which another check mode (for example, CRC) is required to determine whether an error occurs in data.

Parameters of the RS coding may include: a code element length m bits, a quantity k of mother code elements before encoding, a quantity n of mother code elements after encoding, and a quantity l of truncated code elements, where 0<k<n<2^{m}+2, and usually n=2^{m}-1. For a separately encoded data block, a size of the data block before encoding is m×(k-*l*) bits, and a size of the encoded data block after encoding is m×(n-*l*) bits, where m is a code element length, k is a quantity of mother code elements before encoding, n is a quantity of mother code elements after encoding, and 1 is a quantity of truncated code elements.

Terms "system" and "network" may be used interchangeably in embodiments of this application. In addition, "at least one" means one or more, and "a plurality of" means two or more. A term "and/or" describes an association relationship between associated objects and represents that three relationships may exist. For example, A and/or B may represent the following cases: Only A exists, both A and B exist, and only B exists, where A and B may be singular or plural. A character "/" generally indicates an "or" relationship between the associated objects, and "at least one of the following items (pieces)" or a similar expression thereof means any combination of these items, including any combination of singular items (pieces) or plural items (pieces). For example, at least one of a, b, or c may indicate: a, b, c, a and b, a and c, b and c, or a, b, and c, where a, b, and c may be singular or plural.

In addition, unless otherwise stated, ordinal numbers such as "first" and "second" in embodiments of this application are for distinguishing between a plurality of objects, but are not intended to limit an order, a time sequence, priorities, or importance of the plurality of objects. For example, a first message and a second message are merely intended to distinguish between different messages, but do not indicate that the two messages are different in a priority, a sending sequence, or importance.

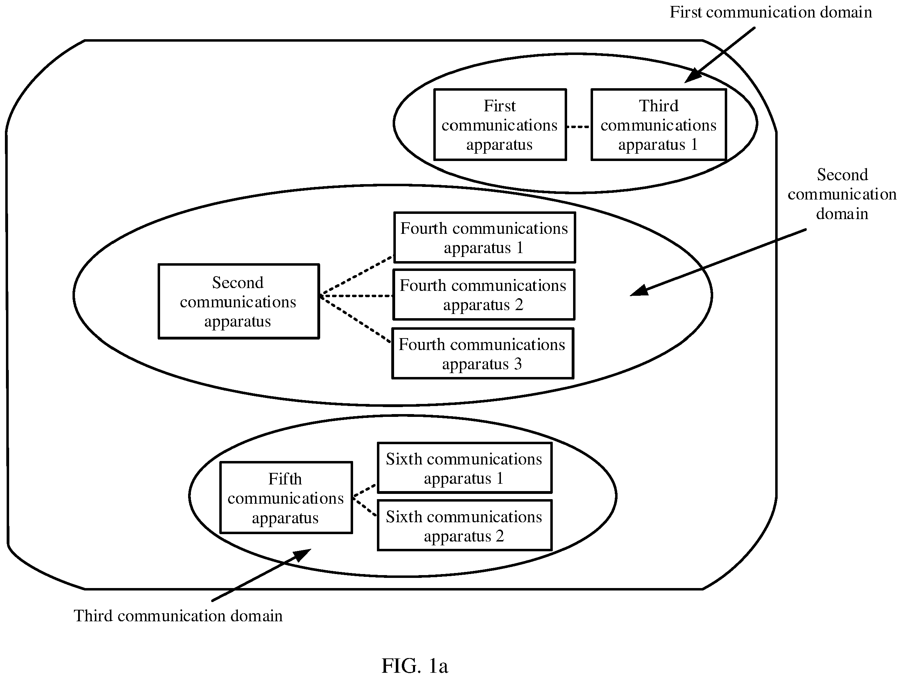

The following describes a network architecture used in embodiments of this application. FIG. 1a shows a network architecture used in an embodiment of this application. As shown in FIG. 1a, a vehicle may use an electrical/electronic (electrical/electronic, E/E) structure, or may use a central computing architecture (central computing architecture, CCA). In this network architecture, a communications apparatus in this application may be a vehicle-mounted device. The vehicle-mounted device may be a device that has a communication function and that is placed or installed in the vehicle. For a vehicle that can perform a self-driving function, a driving decision may be implemented after information collected by a vehicle-mounted device such as a sensor is processed by an ADAS system and a mobile data center (mobile data center, MDC). In addition, an in-vehicle network of a vehicle may include a plurality of electronic control units (electronic control unit, ECU), and all these ECUs may be considered as vehicle-mounted devices. The information collected by the vehicle-mounted device such as the sensor in the vehicle may be further processed by using an ECU, and then sent to a processor of an advanced driver assistance system (Advanced Driver Assistance System, ADAS) or a processor of an MDC for processing. The vehicle-mounted device may be, for example, a head unit, a vehicle-mounted speaker, or a vehicle-mounted microphone. Alternatively, if various terminal devices described below are located on a vehicle (for example, placed in the vehicle or installed in the vehicle), all the terminal devices may be considered as vehicle-mounted terminal devices or referred to as vehicle-mounted devices. By way of example, and not limitation, in embodiments of this application, the vehicle-mounted device placed or installed in the vehicle may further include a wearable device. The wearable device may also be referred to as a wearable intelligent device, an intelligent wearable device, or the like, and is a general term of wearable devices that are intelligently designed and developed for daily wear by using a wearable technology, for example, glasses, gloves, watches, clothes, and shoes. The wearable device is a portable device that can be directly worn on the body or integrated into clothes or an accessory of a user. The wearable device is not only a hardware device, but also implements a powerful function through software support, data exchange, and cloud interaction. Broadly, wearable intelligent devices include full-featured and large-sized devices that can implement all or some of functions without depending on smartphones, for example, smart watches or smart glasses, and include devices that focus on only one type of application function and need to collaboratively work with other devices such as smartphones, for example, various smart bands, smart helmets, or smart jewelry for monitoring physical signs.

To improve management and control of vehicle-mounted devices in a vehicle, the vehicle-mounted devices may be grouped into several communication domains (domain) based on a subsystem. Each communication domain may have one domain controller, each communication domain includes one or more vehicle-mounted devices, and each communication domain has one domain controller (domain controller, DC). The domain controller is configured to manage the vehicle-mounted devices in the communication domain. For example, one vehicle-mounted device in the communication domain is randomly selected as the domain controller, or a vehicle-mounted device that has a coordinated management function in the communication domain may be selected as the domain controller. A device type of the domain controller may be the same as a type of a device in the communication domain, or a device type of the domain controller is different from a type of a device in the domain. For example, a sensor system (which may include, for example, an ADAS sensor) forms a communication domain whose domain controller is an MDC. A drive system may be grouped into a communication domain (for example, a communication domain of an intelligent driving system), the sensor system may be grouped into a communication domain, a control system may be grouped into a communication domain (a communication domain of a vehicle control system), and peripheral devices may be grouped into a communication domain (for example, a communication domain of an entertainment system). The vehicle-mounted devices are grouped into a plurality of communication domains according to a plurality of factors. For example, the vehicle-mounted devices may be grouped according to functions implemented by the vehicle-mounted devices. For example, if several vehicle-mounted devices cooperate with each other to implement a function (for example, a power function), these vehicle-mounted devices may be grouped into a domain. Alternatively, the vehicle-mounted devices may be grouped into different communication domains according to other factors. This is not limited herein. For example, the vehicle-mounted devices may be grouped into communication domains based on spatial locations in a vehicle in which the vehicle-mounted devices are located, or may be further grouped into communication domains based on factors such as spatial locations in the vehicle in which the vehicle-mounted devices are located and a function cooperatively completed by the vehicle-mounted devices.

To reduce harnesses between vehicle-mounted devices, in this application, wireless communication may be implemented between a plurality of vehicle-mounted devices by using communication domains. There may be one or more communication domains in a specific communication area or range. For example, FIG. 1a shows a first communication domain, a second communication domain, and a third communication domain. The communications system may include at least one master node. The master node may be a vehicle-mounted device that communicates with a slave node. Each master node may provide resource scheduling for a slave node in a communication domain, and may communicate with the slave node located in the communication domain. The first communication domain includes one master node (for example, a first communications apparatus 1), and may further include at least one slave node, for example, a third communications apparatus 1. The first communications apparatus 1 establishes a communication connection to the third communications apparatus 1, to form the first communication domain. The second communication domain includes one master node: a second communications apparatus 1. The second communications apparatus 1 may be a device that performs control and management such as allocation and coordination of communication resources in an in-vehicle wireless communication scenario. The second communication domain further includes a plurality of slave nodes, for example, a fourth communications apparatus 1, a fourth communications apparatus 2, and a fourth communications apparatus 3. The second communications apparatus 1 establishes a communication connection to at least one of the fourth communications apparatuses 1 to 3, to form the second communication domain. The third communication domain includes one master node, for example, a fifth communications apparatus 1, and further includes a plurality of slave nodes, for example, a sixth communications apparatus 1 and a sixth communications apparatus 2. The fifth communications apparatus 1 establishes a communication connection to at least one of the sixth communications apparatuses 1 and 2, to form the third communication domain.

It should be noted that FIG. 1a is merely a schematic diagram, and is not intended to limit this application. The scenario architecture in embodiments of this application may alternatively include only one communication domain, or may further include a communication domain formed by more communications apparatuses. This is not limited in this application. For another example, both a quantity of communication domains included in the vehicle architecture and a quantity of communications apparatuses in a communication domain may be greater than or less than those shown in FIG. 1a. In addition, the system architecture described in this application is intended to describe the technical solutions in this application more clearly, but does not constitute a limitation on the technical solutions provided in this application. A person of ordinary skill in the art may learn that, as the system architecture evolves, the technical solutions provided in this application are also applicable to similar technical problems.

In a possible scenario, types of the first communications apparatus 1 and the second communications apparatus 1 may be the same. For example, the first communications apparatus 1 and the second communications apparatus 1 may be DCs. It should be noted that a master node is not limited to a domain controller, and may also be another vehicle-mounted device. For example, in the example shown in FIG. 1a, for a vehicle, all domain controllers are connected to a gateway, and it may be considered that the gateway is a master node, and the domain controllers are slave nodes. For example, the gateway may be used as a master node. In this case, the domain controller may be used as a slave node of the gateway.

In another possible scenario, types of the first communications apparatus 1 and the second communications apparatus 1 may be different. For example, the first communications apparatus 1 in the first communication domain may be a mobile phone, and the third communications apparatus in the first communication domain may include a headset and a wearable device. In the first communication domain, the mobile phone is a master node, and the headset and the wearable device are slave nodes. The second communications apparatus 1 in the second communication domain may be a CDC. The third communications apparatus 1 may be a plurality of types of vehicle-mounted devices, for example, a wearable device such as a headset or a band. Alternatively, the fourth communications apparatuses 1 to 3 in the second communication domain may be vehicle-mounted devices such as a display, a microphone, and a speaker. The fourth communications apparatuses 1 to 3 may also include a plurality of vehicle-mounted devices, for example, a vehicle-mounted speaker and a vehicle-mounted microphone. The CDC is a master node, and the display, microphone, and speaker are slave nodes. For another example, the fifth communications apparatus 1 in the third communication domain may be a passive entry passive start (passive entry passive start, PEPS) system, the sixth communications apparatus 1 in the third communication domain may be a key of a terminal device, and the sixth communications apparatus 2 may be a vehicle key. The sixth communications apparatuses 1 and 2 in the third communication domain may include a body control module (body control module, BCM), a mobile phone key, a vehicle key, and the like. The PEPS system is a master node, and the BCM, the mobile phone key, and the vehicle key are slave nodes. In addition, a master node in a communication domain may also be used as a slave node in another communication domain. For example, the mobile phone in the first communication domain may be used as a slave node in the second communication domain.

For another example, both the master node and the slave node may be vehicle-mounted devices. For example, the first communications apparatus 1 may be a mobile phone, the third communications apparatus 1 may be a headset, and the mobile phone establishes a communication connection to the headset to exchange data. The mobile phone manages the headset. The mobile phone has a resource allocation function, and may allocate resources to the headset, to establish a communication connection between the mobile phone and the headset.

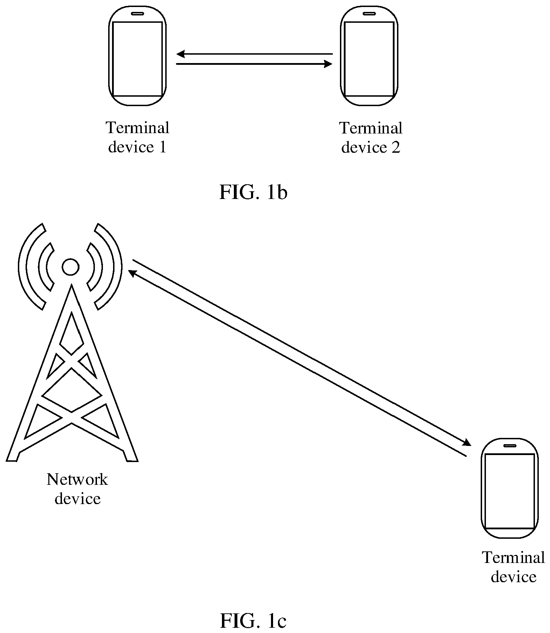

For another example, if the technical solutions provided in embodiments of this application are applied to a V2X communication scenario, FIG. 1b shows an application scenario according to an embodiment of this application. FIG. 1b includes a terminal device 1 and a terminal device 2. The terminal device 1 and the terminal device 2 may communicate with each other through a sidelink (sidelink, SL). In this scenario, a terminal device configured to schedule resources may be used as a master node, and a terminal device configured to listen to resource scheduling may be used as a slave node.

A terminal device may include a device that provides a user with voice and/or data connectivity, for example, may include a handheld device having a wireless connection function, or a processing device connected to a wireless modem. The terminal device may communicate with a core network through a radio access network (radio access network, RAN), and exchange a voice and/or data with the RAN. The terminal device may include user equipment (user equipment, UE), a wireless terminal device, a mobile terminal device, a device-to-device (device-to-device, D2D) communications terminal device, a V2X terminal device, a machine-to-machine/machine-type communications (machine-to-machine/machine-type communications, M2M/MTC) terminal device, an internet of things (internet of things, loT) terminal device, a subscriber unit (subscriber unit), a subscriber station (subscriber station), a mobile station (mobile station), a remote station (remote station), an access point (access point, AP), a remote terminal (remote terminal), an access terminal (access terminal), a user terminal (user terminal), a user agent (user agent), a user device (user device), or the like. For example, the terminal device may include a mobile phone (or referred to as a "cellular" phone), a computer with a mobile terminal device, or a portable, pocket-sized, handheld, or computer built-in mobile apparatus. For example, the terminal device may be a device such as a personal communication service (personal communication service, PCS) phone, a cordless telephone set, a session initiation protocol (session initiation protocol, SIP) phone, a wireless local loop (wireless local loop, WLL) station, or a personal digital assistant (personal digital assistant, PDA). The terminal device may alternatively include a limited device, for example, a device with relatively low power consumption, a device with a limited storage capability, or a device with a limited computing capability. For example, the terminal device includes an information sensing device such as a barcode, radio frequency identification (radio frequency identification, RFID), a sensor, a global positioning system (global positioning system, GPS), or a laser scanner. Alternatively, the terminal device may be a wearable device. For details, refer to the foregoing descriptions. Details are not described herein again.

For another example, if the technical solutions provided in embodiments of this application are applied to communication on a Uu interface in an LTE system or an NR system, FIG. 1c shows an application scenario according to an embodiment of this application. FIG. 1c includes a network device and a terminal device. The network device and the terminal device may communicate with each other through the Uu interface. In this scenario, the network device may be used as a master node, and the terminal device may be used as a slave node.

The network device may include an access network (access network, AN) device such as a base station (for example, an access point), and may be a device that is in an access network and that communicates with a wireless terminal device over an air interface through one or more cells. Alternatively, a master node is, for example, a road side unit (road side unit, RSU) in a V2X technology. The base station may be configured to mutually convert a received over-the-air frame and an internet protocol (IP) packet and serve as a router between the slave node and a rest portion of the access network, where the rest portion of the access network may include an IP network. The RSU may be a fixed infrastructure entity that supports a vehicle-to-everything (vehicle-to-everything, V2X) application, and may exchange a message with another entity that supports the V2X application. Alternatively, an in-vehicle wireless communication scenario may be included, for example, communication between a CDC and each of a vehicle-mounted speaker, a vehicle-mounted microphone, and a mobile phone, and communication between the mobile phone and a wearable device such as a headset. Alternatively, wireless local area communication may be included, for example, communication between a plurality of access points (Access Point, AP) and a plurality of stations (Station). The access network device may further coordinate attribute management of the air interface. For example, the access network device may include an evolved NodeB (NodeB, eNB, or e-NodeB, evolved NodeB) in an LTE system or long term evolution-advanced (long term evolution-advanced, LTE-A), may include a next generation NodeB (next generation NodeB, gNB) in a 5th generation mobile communications technology (5th generation, 5G) new radio (new radio, NR) system, or may include a centralized unit (centralized unit, CU) and a distributed unit (distributed unit, DU) in a cloud access network (cloud radio access network, Cloud RAN) system. This is not limited in embodiments of this application.

In FIG. 1b and FIG. 1c, for example, the terminal device is a mobile phone. The terminal device in embodiments of this application is not limited thereto.

An in-vehicle wireless communication scenario is used as an example. Data transmitted between a master node and a slave node may be service data, and the service data may be classified into different service data based on different service types.

In a possible manner, service data of in-vehicle communication may include service data that requires an extremely low latency, which is collectively referred to as first-type service data below. For example, audio data transmission may include noise reduction service data. The service data includes noise data in an environment collected by a microphone for noise reduction, and the noise data is sent to a CDC. A noise reduction service further includes data transmission from the master node to the slave node. For example, after receiving the noise data, the CDC may generate data with amplitude the same as the noise data and phase opposite to the noise data, and send the data to a speaker to implement noise reduction. A service volume of the noise reduction service occupies several Mbps to dozens of Mbps or even more, accounts for a high proportion of a total service volume of vehicle-mounted communication, and needs to be transmitted by using a large quantity of resources. In this scenario, the noise reduction service includes data transmission from the slave node to the master node. The master node may be a domain manager (for example, the CDC) that manages a microphone and a speaker, and the slave node may include the microphone and the speaker. A service data volume of the noise reduction service data occupies several Mbps to dozens of Mbps or even more, accounts for a high proportion of the total service volume, and needs to be transmitted by using a large quantity of resources. In addition, a single data packet of the noise reduction service data is very small, for example, valid information may be only 16, 24, or 32 bits; a latency requirement is very high, for example, a latency requirement is about 20 µs; and a periodicity is stable, for example, a periodicity is 1/48 kHz (about 20.83 µs). Under the latency requirement, a data coding scheme commonly used in wireless communication, for example, the LDPC coding scheme or the polar coding scheme, has a high encoding and decoding latency due to complexity of the coding scheme, and cannot meet the requirement of an extremely low latency 20 µs required by the noise reduction service. In addition, in the RS coding scheme, error correction and error detection may be performed on data of a single transmission of the noise reduction service data. When a communications apparatus decodes received data according to the RS coding scheme, if a quantity of error bits falls within a corresponding error correction capability range, the communications apparatus may directly perform error correction on the received data according to the RS coding scheme, to obtain correct data. If the quantity of error bits is greater than the error correction capability range but less than an error detection capability range, the communications apparatus may identify that an error occurs during data transmission. If the communications apparatus determines that an error occurs in the received data, considering that the noise reduction service data is sent frequently, and a difference between noise reduction service data sent twice or several consecutive times is small, the communications apparatus may determine, by using noise reduction service data received last time or several previous times, the noise reduction service data received this time, for example, copy data of the last time as the data received this time. Compared with an existing coding scheme, the RS coding scheme can implement error detection on received data without using another error detection manner (for example, CRC check). For a noise reduction service with a very small single data packet (a size of a single packet is, for example, 16 bits, 24 bits, or 32 bits), additional overheads (for example, CRC check bits) can be significantly reduced. Therefore, in this application, the RS coding scheme may be configured for service data that requires an extremely low latency, especially the noise reduction service. For service data with a low latency requirement, to ensure data transmission performance, improve effective resource utilization, and improve link performance, data of another service type may be encoded according to another coding scheme.

In another possible manner, the service data of the in-vehicle communication may further include service data of multimedia services such as an audio/video service, web browsing, and file transfer, which is collectively referred to as second-type service data below. A data packet of this type of service data is large and may be hundreds to thousands of bits, and a service volume accounts for a high proportion in the total service volume. However, this type of service does not have a high latency requirement. Therefore, a coding scheme with better performance than the RS coding scheme may be selected for the second-type service data. For example, a coding scheme that can be selected has higher coding complexity and higher reliability than the RS coding scheme at a same code rate; or a selected coding scheme can achieve same reliability as the RS coding scheme, but has a higher code rate and corresponds to higher spectral efficiency.

In yet another possible manner, the service data of the in-vehicle communication may include dynamic service data, which is collectively referred to as third-type service data below. The third-type service data may be service data of a type such as an application layer message (for example, an operation instruction (for example, a volume adjustment operation) for a vehicle-mounted device) that does not have a high latency requirement, or a control message (for example, a device fault reporting message) of each layer above an access layer such as a device/network layer. A size of a data packet of this type of service data is tens to hundreds of bits, and a latency requirement is not high (above a millisecond-level), or there is no specific latency requirement. Data transmission may occur randomly, and there is no obvious periodicity. This type of service data accounts for a small proportion in a total transmission volume. In this case, to reduce complexity of selecting a coding scheme by the communications apparatus, a coding scheme that is the same as the coding scheme of the first-type service data or the second-type service data may be selected as the coding scheme of the type of service data. For example, the RS coding scheme may be selected. Because a requirement of the RS coding scheme for a coding capability of the communications apparatus is not high, when the RS coding scheme is selected as the coding scheme of the third-type service data, complexity of transmitting the third-type service data can be reduced.

It should be noted that the foregoing classification of service types is merely an example. In a specific implementation process, data may be further classified into service types in another manner. This is not limited herein.

In conclusion, it is difficult to meet requirements of different services because only one coding scheme is used to transmit data or control signaling for data of different service types. This application proposes a communications method. Data is transmitted according to at least two coding schemes, to transmit service data (for example, the first-type service data) that requires an extremely low latency, and ensure link performance and spectral efficiency of data of another service type (for example, the second-type service or the third-type service) in a transmission process.

To better understand the communications method in embodiments of this application, the following specifically uses an in-vehicle wireless communication scenario as an example for description. For another communication scenario, refer to the foregoing wireless communication scenario. Details are not described herein again. The following describes, with reference to the accompanying drawings, the technical solutions provided in embodiments of this application. The method may be performed by two communications apparatuses (or two types of communications apparatuses). The two communications apparatuses are, for example, a first communications apparatus and a second communications apparatus. For ease of description, the first communications apparatus is briefly referred to as a first apparatus below. The first apparatus may be any master node in any communication domain shown in FIG. 1a, or the first apparatus may be a chip system disposed in any master node in any communication domain shown in FIG. 1a. The second communications apparatus is referred to as a second apparatus for short. The second apparatus may be any slave node in any communication domain shown in FIG. 1a, or the second apparatus may be a chip system disposed in any slave node in any communication domain shown in FIG. 1a. The first apparatus and the second apparatus are located in a same communication domain. It should be noted that the communications method in embodiments of this application may be applied to a single communication domain. When there are a plurality of communication domains in the system, at least one of the plurality of communication domains may independently perform the communications method in embodiments of this application. The following uses one communication domain as an example for description.

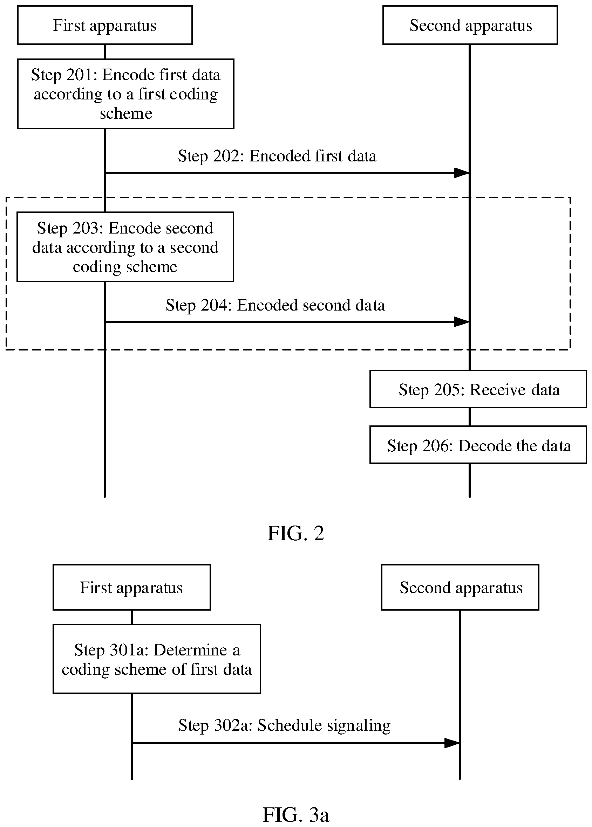

For a downlink data transmission scenario (scenario 1), an example in which the first apparatus sends first data and/or second data to the second apparatus and the second apparatus receives the data sent by the first apparatus is used for description. In this case, the first apparatus may be a master node, and the second apparatus may be a slave node located in a same communication domain as the first apparatus. FIG. 2 is a flowchart of the method. The method includes the following steps.

Step 201: The first apparatus encodes the first data according to a first coding scheme.

Before encoding the first data, the first apparatus may further determine a coding scheme of the first data, that is, the first apparatus may determine, based on the first data, that the coding scheme of the first data is the first coding scheme. The following describes Manner 1 to Manner 3.

Manner 1: The first apparatus may determine, based on a service type of the first data, that the coding scheme of the first data is the first coding scheme.

Different coding schemes can be configured for data of different service types. The service type of the first data may be determined in a plurality of manners. In a possible implementation, a service type identifier may be separately configured for a service type of data, to indicate the service type of the data. A coding scheme of the service type may be correspondingly configured for the service type identifier. Therefore, the first apparatus may determine the coding scheme of the first data based on a service type identifier of the first data and a corresponding configured coding scheme of the service type. For example, a service type identifier 1 may be separately configured for a noise reduction service (a first service type) that requires an extremely low latency, a service type identifier 2 may be configured for streaming media service data (a second service type), and a service type identifier 3 may be separately configured for dynamic service data (a third service type). In a possible implementation, data of one service type may correspond to one coding scheme, and the identifier 1 to the identifier 3 may one-to-one correspond to coding schemes. Alternatively, to reduce a quantity of configured coding schemes, data of one or more service types may correspond to one coding scheme, that is, different service types may also correspond to at least two coding schemes. For example, two coding schemes may be configured in a system, including a first coding scheme and a second coding scheme. For example, a coding scheme for data of the identifier 1 and the identifier 2 may be configured as the first coding scheme, and a coding scheme for data of the identifier 3 may be configured as the second coding scheme. For example, the first coding scheme may be an RS coding scheme, and the second coding scheme may be another coding scheme such as a polar coding scheme. In this scenario, a coding scheme corresponding to data may be determined according to a latency requirement of the data. For example, a coding scheme for data of a service type that requires an extremely low latency may correspond to the first coding scheme, to meet a latency requirement of the data of the service type. A coding scheme for data of a service type that has no latency requirement or has a low latency requirement may correspond to the second coding scheme, to ensure transmission performance of this type of service data. In another possible implementation, a corresponding coding scheme may be further determined based on a single transmission amount of data of a service type. For example, a coding scheme of data with a small data packet and a small single transmission amount may correspond to the first coding scheme, to improve transmission efficiency. A coding scheme of data with a large data packet and a large single transmission amount may correspond to the second coding scheme, to improve transmission performance.

Manner 2: A priority may be configured for data, and a coding scheme of the priority may be correspondingly configured for the priority corresponding to the data. Therefore, the first apparatus may determine, based on a priority of the first data, that the coding scheme of the first data is the first coding scheme.

In a manner in which the first apparatus may determine a priority of data based on a service type of the data, a correspondence between the priority of the data and a coding scheme of the data may be determined based on a correspondence between the service type of the data and the coding scheme of the data. With reference to the solution in Manner 1, if it is determined that different service types correspond to the first coding scheme and the second coding scheme, the first coding scheme and the second coding scheme that correspond to priorities may be determined based on the priorities corresponding to the service types. For example, if it is determined that the priorities of the data include a first priority, a second priority, and a third priority, the first priority corresponds to the first service type, the second priority corresponds to the second service type and the third service type, and the third priority corresponds to a fourth service type, it may be determined that a coding scheme of data corresponding to the first priority is the first coding scheme, and a coding scheme of data corresponding to the second priority and the third priority is the second coding scheme.

For another priority determining manner, a correspondence between a priority and a coding scheme may be separately configured. This is not limited herein.

Manner 3: By configuring a transmission mode for data, a coding scheme of the transmission mode may be correspondingly configured for the transmission mode corresponding to the data. Therefore, the first apparatus may determine, based on a transmission mode of the first data, that the coding scheme of the first data is the first coding scheme.

In different transmission modes, the first apparatus differently processes, at each protocol layer, a data packet of sent data. Therefore, a transmission latency of the sent data is also affected. In a possible transmission mode, when data is transparently transmitted by using a layer 2 protocol packet or a layer 3 protocol packet, a process in which the first apparatus repackages the data can be avoided. Therefore, in this transmission mode, a latency of transmitting the first data from the first apparatus to the second apparatus is short. Therefore, the first coding scheme may be configured for data in this transmission mode, to further shorten a data transmission latency. In another possible transmission mode, after receiving a data packet of data from a higher layer, the first apparatus encodes the data to generate an encoded data packet, and then forwards the encoded data packet to a next protocol layer. When data passes through each protocol layer, data needs to be repackaged for the protocol layer, to add a corresponding header. Therefore, in the transmission mode, a data transmission latency may be long, and the second coding scheme may be correspondingly configured for the transmission mode.

In still another possible transmission mode, when being forwarded at each different protocol layer, a data packet may need to be sent at the same time as other data during processing of the data packet at each protocol layer. Therefore, a waiting time may need to be set according to a different quality of service (quality of service, QoS) requirement of a service bearer corresponding to each piece of data. For example, different service bearers have different latency requirements. Some service bearers have a high latency requirement, and some service bearers have a low latency requirement. Different waiting time may be set for different data according to different latency requirements.

In yet another possible transmission mode, when a data packet of data transmitted between the first apparatus and the second apparatus is forwarded at each different protocol layer, the data packet of the data may be directly forwarded. Therefore, during processing of the data packet of the data at each protocol layer, a waiting time does not need to be set, to shorten a data transmission latency. In this transmission mode, a coding scheme of the data may also be set to the first coding scheme, to improve data transmission efficiency.

Further, the first apparatus may schedule a transmission resource used by the second apparatus to receive the first data, so that the second apparatus determines that the coding scheme of the first data is the first coding scheme or a coding scheme of the second data is the second coding scheme. There may be a plurality of specific scheduling manners. The following uses Manner a1 to Manner a3 as examples for description.

Manner a1: FIG. 3a is a schematic flowchart of a communications method according to this application. The method includes the following steps.

Step 301a: The first apparatus determines the coding scheme of the first data.

For a specific determining manner, refer to Manner 1 to Manner 3. Details are not described herein again.

Step 302a: The first apparatus sends scheduling signaling to the second apparatus. The second apparatus determines the coding scheme of the first data based on the scheduling signaling, to decode the first data sent by the first apparatus. The scheduling signaling may be higher layer signaling or physical layer signaling. This is not limited herein. The following uses an example to describe a manner of sending the scheduling signaling.

In a possible implementation, indication information carried in the scheduling signaling may include at least one of the following: the service type of the first data, the priority of the first data, the transmission mode of the first data, the first coding scheme, and the like.

The first apparatus may determine, according to a method for determining the first coding scheme, the indication information carried in the scheduling signaling. For example, if the first apparatus determines the coding scheme of the first data based on the service type of the first data, the indication information carried in the scheduling signaling may include the service type of the first data. If the first apparatus determines the coding scheme of the first data based on the priority of the first data, the indication information carried in the scheduling signaling may include the priority of the first data. If the first apparatus determines the coding scheme of the first data based on the transmission mode of the first data, the indication information carried in the scheduling signaling may include the transmission mode of the first data.

Alternatively, after determining the first coding scheme, the first apparatus may determine, according to another method, the indication information carried in the scheduling signaling. This is not limited herein. For example, if the first apparatus determines the coding scheme of the first data based on the service type of the first data, the indication information carried in the scheduling signaling may include at least one of the following: the service type of the first data, the priority of the first data, or the transmission mode of the first data. If the first apparatus determines the coding scheme of the first data based on the priority of the first data, the indication information carried in the scheduling signaling may include at least one of the following: the service type of the first data, the priority of the first data, or the transmission mode of the first data. If the first apparatus determines the coding scheme of the first data based on the transmission mode of the first data, the indication information carried in the scheduling signaling may include at least one of the following: the service type of the first data, the priority of the first data, or the transmission mode of the first data.

For example, the indication information indicates that the coding scheme of the first data is the first coding scheme. For example, the indication information may occupy a first field, the first field occupies 1 bit, 0 indicates the first coding scheme, and 1 indicates the second coding scheme. Alternatively, the first field occupies 2 bits, 0 indicates the first service type, 1 indicates the second service type, 3 indicates the third service type, and 4 indicates the fourth service type. Alternatively, the first field occupies 2 bits, 0 indicates the first priority, 1 indicates the second priority, and 3 indicates the third priority. Alternatively, the first field occupies 2 bits, 0 indicates a first transmission mode, 1 indicates a second transmission mode, and 3 indicates a third transmission mode. The foregoing indication manner is merely an example. In a specific application, the indication manner may be determined according to a requirement. This is not limited herein.

In a specific implementation process, a field occupied by the indication information carried in the scheduling signaling may reuse an original field in the scheduling signaling, or a new field may be separately set for the coding scheme. This is not limited herein. Fields that are used to determine the coding scheme of the first data in the scheduling signaling below may be collectively referred to as the first field. In another possible implementation, the first field may further directly indicate the coding scheme of the first data, that is, directly indicate the first coding scheme.

Therefore, after receiving the scheduling signaling, the second apparatus may determine that the coding scheme of the received first data is the first coding scheme, and decode the first data according to the first coding scheme.

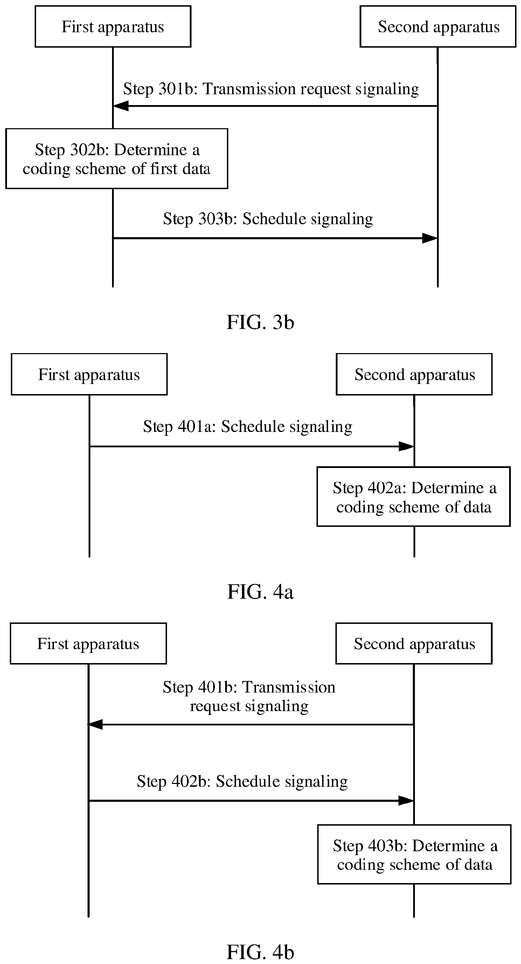

Manner a2: FIG. 3b is a schematic flowchart of a communications method according to this application. The method includes the following steps.

Step 301b: The first apparatus receives transmission request signaling sent by the second apparatus.

In a possible implementation, the transmission request signaling may carry transmission information that is for transmitting the first data and that is determined by the second apparatus, and is used by the first apparatus to determine a transmission resource for the first data and the coding scheme of the first data. The transmission information may occupy a second field, and the second field may be used to indicate at least one of the following: the first coding scheme, the priority of the first data, the service type of the first data, or the transmission mode of the first data.

The second apparatus may determine, based on a channel state collected by the second apparatus, or based on a data configuration parameter such as a data coding scheme, a data service type, or a data transmission mode supported by the second apparatus, that the coding scheme corresponding to the first data transmitted between the first apparatus and the second apparatus is the first coding scheme. Therefore, the second apparatus instructs, by using the transmission request signaling, the first apparatus to use the first coding scheme to transmit the first data.

Step 302b: The first apparatus determines the coding scheme of the first data based on the transmission request signaling.

With reference to the first possible implementation in step 301b, for example, after receiving the transmission request signaling from the second apparatus, the first apparatus determines the coding scheme of the first data based on the transmission request signaling.

With reference to the second possible implementation in step 301b, the first apparatus may determine, based on the second field carried in the transmission request signaling, that the coding scheme of the first data is the first coding scheme.

Step 303b: The first apparatus may further send scheduling signaling to the second apparatus.

The scheduling signaling is used to carry indication information, and the indication information indicates that the coding scheme of the first data is the first coding scheme. The indication information may be sent by occupying the first field, or the scheduling signaling may be sent to the second apparatus by using another field. This is not limited herein.

Manner a3: The first apparatus and the second apparatus may determine, in a preconfigured manner, that the coding scheme of the first data is the first coding scheme. The preconfigured manner may be specified in a protocol, or may be configured for the first apparatus when the first apparatus is delivered from a factory or maintained, or may be configured for the first apparatus when the second apparatus is delivered from a factory or maintained, or may be another preconfigured manner. This is not limited herein.

For example, different coding scheme sets may be configured for different communication domains, or coding schemes corresponding to data sent by the first apparatus and the second apparatus may be configured for different service types supported by the first apparatus and the second apparatus in a communication domain. In this case, the first apparatus does not need to send a scheduling signaling indication to the second apparatus to determine the coding scheme of the first data, to reduce signaling overheads.

After determining that the coding scheme of the first data is the first coding scheme, for example, the first coding scheme is the RS coding scheme, in an encoding process, the first apparatus may determine a coding parameter in the RS coding scheme based on a data packet size of the first data. For example, the first apparatus may determine, based on the data packet size, a quantity n of encoded mother code elements and a quantity I of truncated code elements in the RS coding parameter. Therefore, the data is encoded based on the quantity n of encoded mother code elements and the quantity I of truncated code elements.

Step 202: The first apparatus sends the encoded first data to the second apparatus.

The first apparatus may send the encoded first data in a unicast mode, a broadcast mode, or a multicast mode. This is not limited herein.

Step 203: The first apparatus encodes the second data according to the second coding scheme.

The first data is different from the second data, and the second coding scheme is different from the first coding scheme. The first data and the second data may be determined as different data in a plurality of manners. The following describes Example 1 to Example 3.

Example 1: The service type of the first data is different from a service type of the second data. In this case, the first apparatus may determine, based on a service type of data, a coding scheme corresponding to the data. With reference to the foregoing classification of the service types, if a corresponding identifier is configured for a service type, it may be determined, based on a service type identifier of the data, that the service type of the first data and the service type of the second data are different. With reference to the foregoing correspondence between a service type and a coding scheme, if the first data is of a service type that requires an extremely low latency, the first apparatus may determine the coding scheme of the first data as the first coding scheme. The first coding scheme may be the RS coding. If the first data is of a dynamic service type, the first apparatus may determine the coding scheme of the first data as the second coding scheme.

Example 2: In different service scenarios, the first data and the second data may further have different configuration parameters. For example, a transmission resource configured for the first data is different from a transmission resource configured for the second data. Therefore, the first apparatus may further determine, based on a fact that the transmission resource configured for the first data is different from the transmission resource configured for the second data, that the first data is different from the second data. The transmission resource may include a time domain resource, a frequency domain resource, a code domain resource, and the like.

Example 3: The first apparatus may further determine, based on a data transmission parameter, that the first data is different from the second data.

For example, the data transmission parameter may include a modulation and coding scheme, a multiple-input multiple-output mode, an automatic repeat request parameter, a priority, and a transmission mode.

It should be noted that the first apparatus may also determine the coding scheme of the second data by using a plurality of method. For details, refer to descriptions of Manner 1 to Manner 3 in step 201 in which the first apparatus determines the coding scheme of the first data. Details are not described herein again.

Further, before sending the second data, the first apparatus may schedule a transmission resource used by the second apparatus to receive the second data, so that the second apparatus determines that the coding scheme of the second data is the second coding scheme. For a specific implementation, refer to the description of interaction between the first apparatus and the second apparatus in Manner a1 to Manner a3. Details are not described herein again.

Step 204: The first apparatus sends the encoded second data to the second apparatus.

The first apparatus may send the encoded second data in a unicast mode, a broadcast mode, or a multicast mode. This is not limited herein.

It should be noted that step 203 and step 204 may be optional steps of the first apparatus, and may not be performed simultaneously with step 201 and step 202, or may not be performed, or may be performed separately, or may be performed before step 201 and step 202, or may be performed after step 201 and step 202, or may be performed simultaneously with step 201 and step 202. This is not limited herein. Therefore, step 203 and step 204 are represented by a dashed box in FIG. 2.

Step 205: The second apparatus receives data.

The data received by the second apparatus may be the first data or the second data sent by the first apparatus to the second apparatus. The data may be service data of any service type described in the foregoing embodiment.

Step 206: The second apparatus decodes the data according to the first coding scheme and/or the second coding scheme.

The first coding scheme is one of at least two coding schemes. The second coding scheme is one of at least two coding schemes, and the first coding scheme is different from the second coding scheme.

In step 206, the second apparatus may determine the first coding scheme or the second coding scheme in a plurality of manners. The following uses Manner c1 to Manner c3 as examples for description.

Manner c1: As shown in FIG. 4a, the method includes the following steps.

Step 401a: The second apparatus receives the scheduling signaling sent by the first apparatus.

Step 402b: The second apparatus may determine, based on the scheduling signaling sent by the first apparatus, that a coding scheme of the data is the first coding scheme or the second coding scheme. The scheduling signaling may be used by the first apparatus to determine the coding scheme of the data sent by the first apparatus. For example, before determining to send the first data, the first apparatus may send the scheduling signaling to the second apparatus after determining that the coding scheme of the first data is the first coding scheme. The scheduling signaling may include the first field. For content indicated in the first field, refer to the embodiments in FIG. 3a and FIG. 3b. Details are not described herein again.

In a possible implementation, before step 203, the first apparatus determines that the coding scheme of the first data is the first coding scheme. In this case, the first apparatus may send the scheduling signaling to the second apparatus, and the scheduling signaling may be used to determine that the coding scheme of the data is the first coding scheme. Therefore, after receiving the scheduling signaling, the second apparatus may determine, by using the indication information carried in the scheduling signaling, that the coding scheme of the data is the first coding scheme. For the indication information carried in the scheduling signaling, refer to the indication information carried in the scheduling signaling in the embodiments in FIG. 3a to FIG. 4b. Details are not described herein again. After the second apparatus determines that the coding scheme of the data is the first coding scheme, the second apparatus may determine a corresponding decoding scheme according to the first coding scheme, to decode the data. For example, if the second apparatus determines that the first coding scheme is the RS coding scheme, the second apparatus may determine a corresponding RS decoding scheme according to the RS coding scheme, to decode the data. Further, the second apparatus may further determine the coding parameter in the RS coding scheme based on a data packet size of the data. For example, the second apparatus may determine, based on the data packet size, a quantity n of encoded mother code elements and a quantity l of truncated code elements in the RS coding parameter. Therefore, the data is decoded based on the quantity n of encoded mother code elements and the quantity l of truncated code elements.

Manner c2: Before the first apparatus sends the data, as shown in FIG. 4b, the method includes the following steps.

Step 401b: The second apparatus sends the transmission request signaling to the first apparatus.

The transmission request signaling may be used to send, to the first apparatus, determined information about a transmission resource for transmitting the data. Alternatively, the transmission request signaling may be used to indicate a coding scheme corresponding to data that can be received by the second apparatus. For another example, the transmission request signaling may be further used to indicate configuration parameters such as a service type and a transmission mode of the data that can be received by the second apparatus. Therefore, the first apparatus may determine a coding scheme of the data based on the transmission request signaling. In a possible implementation, the transmission request signaling may include the second field, and the second field may be used to indicate at least one of the following: a coding scheme of the data, a service type of the data, a transmission mode of the data, and a priority of the data. For example, the second apparatus supports only the first coding scheme, or the service type of the data that can be received by the second apparatus includes audio data of a noise reduction service type or audio data of a non-noise-reduction service type.

Step 402b: The first apparatus sends scheduling signaling to the second apparatus.

The first apparatus may determine, based on the transmission request instruction sent by the second apparatus, to send the first coding scheme or the second coding scheme, so that the first apparatus can send the scheduling signaling to the second apparatus. The scheduling signaling may be used to indicate that a coding scheme that is of the data and that is determined by the first apparatus is the first coding scheme or the second coding scheme.

Step 403b: The second apparatus may determine, based on the received scheduling signaling, that the coding scheme of the first data is the first coding scheme. Therefore, the received data is decoded according to the first coding scheme.

Alternatively, before the first apparatus sends the second data to the second apparatus, the first apparatus may determine, based on the transmission request signaling sent by the second apparatus, to send the second coding scheme of the second data, so that the first apparatus can send the scheduling signaling to the second apparatus. The scheduling signaling may be used to indicate that a coding scheme that is of the second data sent by the first apparatus and that is determined by the first apparatus is the second coding scheme. Therefore, the second apparatus may decode the received data based on the received scheduling signaling according to the second coding scheme. For specific manners of sending the transmission request signaling and receiving the scheduling signaling, refer to the implementation of the second apparatus in Manner b2. Details are not described herein again.

Manner c3: The second apparatus uses any one of at least two preconfigured coding schemes as the first coding scheme, so that the second apparatus can perform blind detection on the data according to the determined first coding scheme. For example, the blind detection process may be that the second apparatus randomly selects a coding scheme from the at least two coding schemes as the first coding scheme to decode the received data. If decoding in the first coding scheme succeeds, the second apparatus stops attempting to decode the received data according to another coding scheme in the at least two preconfigured coding schemes. If decoding in the first coding scheme fails, the second apparatus randomly selects a coding scheme from other coding schemes from the at least two preconfigured coding schemes to decode the received data, and repeats the foregoing decoding process until the received data can be successfully decoded according to one of the coding schemes.

Alternatively, the second apparatus uses any one of the at least two preconfigured coding schemes as the second coding scheme, so that the second apparatus can perform blind detection on the data according to the determined second coding scheme. In this manner, the first apparatus does not need to indicate, to the second apparatus, a coding scheme to be used to decode the data, so that signaling overheads can be effectively reduced.

In a possible implementation, the first coding scheme may be the RS coding scheme. Therefore, the second apparatus may first decode the data according to a coding scheme with low complexity and a short latency. When the data is the first data sent by the first apparatus, and a coding scheme of the first data is the RS coding scheme, the data may be decoded in time, to meet a latency requirement of the first data.

Further, the second apparatus may further decode the data according to the second coding scheme. The second coding scheme may be any one of the at least two preconfigured coding schemes other than the first coding scheme.

It should be noted that a process in which the second apparatus decodes the data according to the second coding scheme and a process in which the second apparatus decodes the data according to the first coding scheme may be alternatively performed in step 206, or may be performed in sequence in step 206. For example, in a scenario in which the first apparatus simultaneously sends the first data and the second data, the first data is encoded according to the first coding scheme, and the second data is encoded according to the second coding scheme. In this scenario, the second apparatus may first decode the data according to the first coding scheme, and if the decoding succeeds, the second apparatus determines that the data is the first data sent by the first apparatus. If the decoding fails, the second apparatus may decode the data according to the second coding scheme. If the data can be decoded according to the second coding scheme, the second apparatus determines that the data is the second data sent by the first apparatus. For another example, the second apparatus may randomly select the second coding scheme or the first coding scheme to decode the received data. The sequence of decoding the received data according to the second coding scheme or the first coding scheme may be determined according to an actual requirement. This is not limited herein.

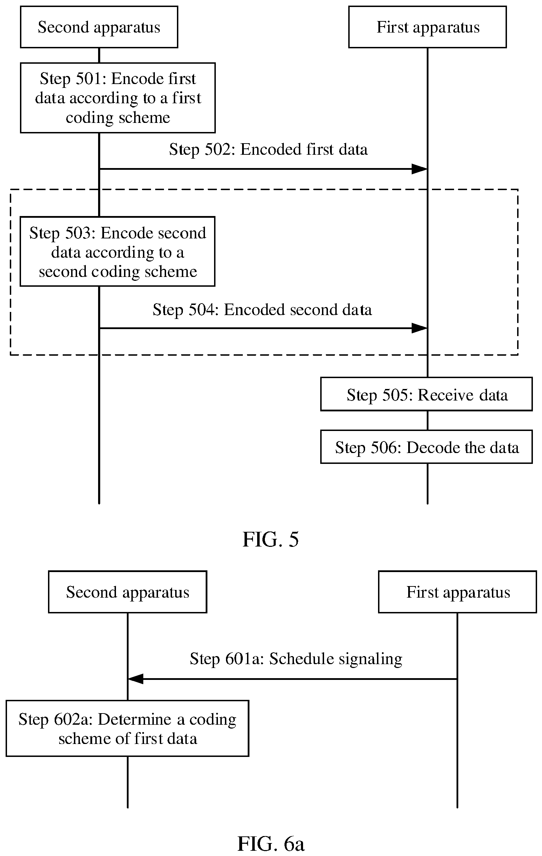

For an uplink data transmission scenario (scenario 2), an embodiment of this application provides a communications method. FIG. 5 is a flowchart of the method. In this embodiment, an example in which a second apparatus sends first data and/or second data to a first apparatus is described, and the following steps may be included.

Step 501: The second apparatus encodes the first data according to a first coding scheme.

The second apparatus may determine a coding scheme of the first data as the first coding scheme in a plurality of manners. The following uses Manner b 1 to Manner b3 as examples for description.

Manner b 1: FIG. 6a is a schematic flowchart of a communications method according to this application. The method includes the following steps.

Step 601a: The second apparatus may receive scheduling signaling sent by the first apparatus.

Step 602a: The second apparatus determines, based on the scheduling signaling, that the coding scheme of the first data is the first coding scheme.

For a specific implementation, refer to Manner a1 of sending the scheduling signaling to determine that the coding scheme of the first data is the first coding scheme in scenario 1. Details are not described herein again.

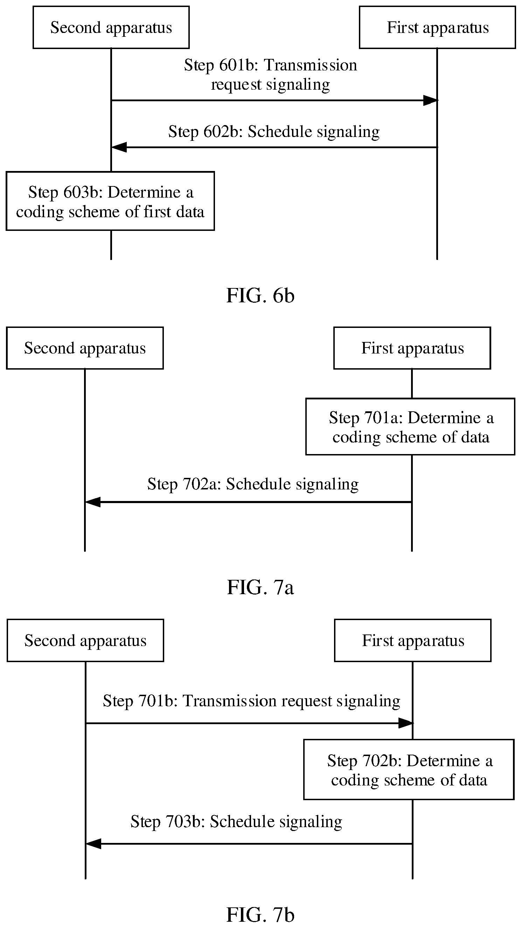

Manner b2: FIG. 6b is a schematic flowchart of a communications method according to this application. The method includes the following steps.

Step 601b: The second apparatus may send transmission request signaling to the first apparatus.

Step 602b: After the first apparatus determines the coding scheme of the first data, the first apparatus sends scheduling signaling to the second apparatus.

For a specific implementation, refer to Manner a2 of sending the transmission request signaling to determine that the coding scheme of the first data is the first coding scheme in scenario 1. Details are not described herein again.

Step 603b: The second apparatus determines, based on the scheduling signaling sent by the first apparatus, that the coding scheme of the first data is the first coding scheme. Further, the second apparatus may encode the first data according to the first coding scheme.

For a specific implementation, refer to Manner a2 in which the second apparatus determines, by using the scheduling signaling sent by the first apparatus, that the coding scheme of the first data is the first coding scheme in scenario 1. Details are not described herein again.

Manner b3: The second apparatus may determine, in a preconfigured manner, that the coding scheme of the first data is the first coding scheme.

For a specific implementation, refer to Manner a3 of determining, in a preconfigured manner, that the coding scheme of the first data is the first coding scheme in scenario 1. Details are not described herein again.

Step 502: The second apparatus sends the encoded first data to the first apparatus.

Step 503: The second apparatus encodes the second data according to a second coding scheme.

Before the second apparatus sends the second data, the first apparatus may further schedule a resource for transmitting the second data between the second apparatus and the first apparatus, so that the second apparatus determines that a coding scheme of the second data is the second coding scheme. For a specific implementation, refer to the description of interaction between the first apparatus and the second apparatus in Manner b1 to Manner b3. Details are not described herein again.

Step 504: The second apparatus sends the encoded second data to the first apparatus.

It should be noted that step 503 and step 504 may be optional steps of the first apparatus, and may not be performed simultaneously with step 501 and step 502, or may not be performed, or may be performed separately, or may be performed before step 501 and step 502, or may be performed after step 501 and step 502, or may be performed simultaneously with step 501 and step 502. This is not limited herein. Therefore, step 503 and step 504 are represented by a dashed box in FIG. 5.

Step 505: The first apparatus receives data.

Step 506: The first apparatus decodes the data.

The first apparatus may decode the data according to the first coding scheme, or the first apparatus decodes the data according to the second coding scheme.

In the uplink data transmission scenario, the first apparatus may determine the first coding scheme or the second coding scheme in a plurality of manners. The following uses Manner d1 to Manner d3 as examples for description.

Manner d1: Before the second apparatus sends the data, as shown in FIG. 7a, the method includes the following steps.

Step 701a: The first apparatus determines a coding scheme of the received data.

The first apparatus may determine that the coding scheme of the data is the first coding scheme when determining that the second apparatus sends the first data, or the first apparatus may determine that the coding scheme of the data is the second coding scheme when determining that the second apparatus sends the second data. For details, refer to the foregoing embodiment in which the first apparatus determines the coding scheme of the first data or the coding scheme of the second data. Details are not described herein again.

Step 702a: The first apparatus sends scheduling signaling to the second apparatus.

That the scheduling signaling may be used to indicate the second apparatus to determine, based on the scheduling signaling, a coding scheme of the data to be sent by the second apparatus may specifically include: The scheduling signaling may be used by the second apparatus to determine that the coding scheme of the first data to be sent by the second apparatus is the first coding scheme, and/or the scheduling signaling may be used by the second apparatus to determine that the coding scheme of the second data to be sent by the second apparatus is the second coding scheme. Further, the scheduling signaling may further include a transmission resource that is occupied for sending the data and that is configured by the first apparatus for the second apparatus.

For example, the second apparatus supports only the first coding scheme, or a service type of the data that can be received by the second apparatus includes audio data of a noise reduction service type or audio data of a non-noise-reduction service type.

Therefore, before the second apparatus sends the first data, the first apparatus may determine, based on a configuration parameter of the first data sent by the second apparatus, to send the first coding scheme of the first data, so that the first apparatus can send the scheduling signaling to the second apparatus. The scheduling signaling may be used to indicate the second apparatus to determine a coding scheme of the data as the first coding scheme. In addition, the first apparatus may decode the received data according to the first coding scheme.

Manner d2: Before the second apparatus sends the data, as shown in FIG. 7b, the method includes the following steps.

Step 701b: The first apparatus receives transmission request signaling sent by the second apparatus.

Step 702b: The first apparatus may determine the coding scheme of the data based on the transmission request signaling sent by the second apparatus.

The transmission request signaling may be used by the first apparatus to determine the coding scheme of the data sent by the second apparatus. The transmission request signaling may be used to send, to the second apparatus, information about a determined transmission resource for transmitting the data. Alternatively, the transmission request signaling may be used to indicate a coding scheme corresponding to data that can be received by the first apparatus. For another example, the transmission request signaling may be further used to indicate configuration parameters such as a service type and a transmission mode of the data that can be received by the first apparatus. For example, before determining to send the first data, the second apparatus may send the transmission request signaling, to request to obtain configuration information such as a transmission resource allocated by the first apparatus to the second apparatus. After receiving the transmission request signaling sent by the second apparatus, the first apparatus determines that the coding scheme of the first data is the first coding scheme.

Step 703b: The first apparatus sends scheduling signaling to the second apparatus. The scheduling signaling may be used to allocate, to the second apparatus, a transmission resource used by the second apparatus to send the first data or the second data and a coding scheme of the corresponding data (for example, may include the coding scheme of the first data and the coding scheme of the second data). The scheduling signaling may include a first field. For content indicated in the first field, refer to the embodiment in FIG. 2. Details are not described herein again.

In a possible implementation, the first apparatus determines that the second apparatus needs to send the first data. In this case, the first apparatus may determine that the coding scheme of the first data is the first coding scheme. Therefore, the first apparatus may send the scheduling signaling to the second apparatus before the second apparatus sends the first data. The scheduling signaling may be used to determine that the coding scheme of the data is the first coding scheme. Therefore, after receiving the scheduling signaling, the second apparatus may determine, by using indication information carried in the scheduling signaling, that the coding scheme of the data is the first coding scheme. For the indication information carried in the scheduling signaling, refer to the indication information carried in the scheduling signaling in the embodiment in FIG. 2. Details are not described herein again. After the first apparatus receives the data sent by the second apparatus, the first apparatus may determine a corresponding decoding scheme according to the determined first coding scheme, to decode the data. For a specific decoding scheme, refer to the implementation in scenario 1. Details are not described herein again.

For another example, before the second apparatus sends the second data to the first apparatus, the first apparatus may determine, based on the transmission request signaling sent by the second apparatus, to send the second coding scheme of the second data, so that the first apparatus can send the scheduling signaling to the second apparatus. The scheduling signaling may be used to indicate that a coding scheme that is of the second data sent by the second apparatus and that is determined by the first apparatus is the second coding scheme. In addition, the second apparatus may decode the received data according to the second coding scheme. For specific manners of sending the transmission request signaling and receiving the scheduling signaling, refer to the implementation of the second apparatus in Manner c2. Details are not described herein again.

Manner c3: The first apparatus uses any one of at least two preconfigured coding schemes as the first coding scheme, and performs blind detection on the data. In this manner, the first apparatus does not need to determine a coding scheme used by the second apparatus to encode the data, so that complexity of processing required by the first apparatus to determine a coding scheme can be reduced. In addition, the first apparatus does not need to send scheduling signaling to the second apparatus, to effectively reduce signaling overheads.

For a specific implementation, refer to the implementation in scenario 1. Details are not described herein again.

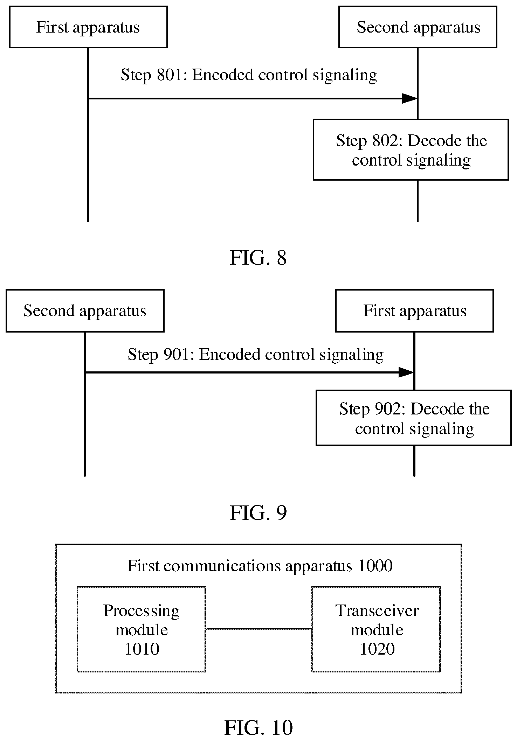

An embodiment of this application further provides a communications method, which may be applied to a downlink transmission control signaling scenario (scenario 3). As shown in FIG. 8, a first apparatus sends control signaling to a second apparatus. The method includes the following steps.

Step 801: The first apparatus sends the encoded control signaling to the second apparatus.

A coding scheme of the control signaling is a first coding scheme.

For example, the control signaling may include signaling used for resource scheduling, resource allocation, channel state reporting, and device capability reporting. The control signaling may include at least one of the following: physical layer signaling and higher layer signaling.

The coding scheme of the control signaling may be preconfigured. In a possible implementation, to reduce complexity caused by setting a plurality of coding schemes, a coding scheme of the control signaling may be set to be the same as a coding scheme of transmitted data, to reduce types of coding schemes determined by the first apparatus, and reduce complexity of processing the control signaling by the first apparatus. For example, the transmitted data is first data. If a coding scheme determined for the first data is an RS coding scheme, the coding scheme of the control signaling is also the RS coding scheme. If a coding scheme determined for the first data is another coding scheme, the coding scheme of the control signaling may also be the another coding scheme.

When a coding scheme of the control signaling is the RS coding scheme, the first apparatus may further determine a parameter of the coding scheme of the control signaling based on a size, a format, or a type of the control signaling, to encode the control signaling based on the parameter of the coding scheme of the control signaling, for example, generate a code block based on the control signaling and the parameter (for example, a mother code and a truncation mode) of the coding scheme of the control signaling, to generate the encoded control signaling.

In another possible implementation, a corresponding coding scheme may be further configured for the control signaling. For a specific method for determining the coding scheme of the control signaling, refer to the method for determining the coding scheme of the first data by the first apparatus. Details are not described herein again.

Step 802: The second apparatus receives the control signaling sent by the first apparatus, and decodes the control signaling according to the coding scheme of the control signaling.

For example, the control signaling may be any type of control signaling in this application. This is not limited herein.

The coding scheme of the control signaling may be preconfigured. In a possible implementation, to reduce complexity caused by setting a plurality of coding schemes, the coding scheme of the control signaling may be set to be the same as the coding scheme of the first data, to reduce complexity of determining the coding scheme by the second apparatus and performing decoding according to the coding scheme.

With reference to the downlink data transmission scenario in scenario 1, if the coding scheme determined for the first data is the RS coding scheme, the coding scheme of the control signaling is also the RS coding scheme, so that the second apparatus can decode the control signaling according to the RS coding scheme; or if the coding scheme determined for the first data is another coding scheme, the coding scheme of the control signaling may also be the another coding scheme, so that the second apparatus can decode the control signaling according to the coding scheme. Coding and decoding can be faster in the RS coding scheme. Therefore, when the RS coding scheme is used for the control signaling, a latency of processes such as scheduling and resource allocation can be shortened.

When the coding scheme of the control signaling is the RS coding scheme, the second apparatus may further determine a parameter of the coding scheme of the control signaling based on the size, the format, or the type of the control signaling, to decode the control signaling based on the parameter of the coding scheme of the control signaling, for example, decode a code block based on the control signaling and the parameter (for example, a mother code and a truncation mode) of the coding scheme of the control signaling, to generate the decoded control signaling.

An embodiment of this application further provides a communications method, which may be applied to a downlink transmission control signaling scenario (scenario 4). As shown in FIG. 9, the method includes the following steps.

Step 901: A second apparatus sends encoded control signaling to a first apparatus.

A coding scheme of the control signaling is a first coding scheme.

For example, the control signaling may include signaling used for resource scheduling, resource allocation, channel state reporting, and device capability reporting. The control signaling may include at least one of the following: physical layer signaling and higher layer signaling.

The coding scheme of the control signaling may be preconfigured. In a possible implementation, to reduce complexity caused by setting a plurality of coding schemes, a coding scheme of the control signaling may be set to be the same as a coding scheme of transmitted data, to reduce types of coding schemes determined by the second apparatus, and reduce complexity of processing the control signaling by the second apparatus. For example, the transmitted data is first data. If a coding scheme determined for the first data is an RS coding scheme, the coding scheme of the control signaling is also the RS coding scheme. If a coding scheme determined for the first data is another coding scheme, the coding scheme of the control signaling may also be the another coding scheme.

Coding and decoding can be faster in the RS coding scheme. Therefore, when the RS coding scheme is used for the control signaling, a latency of processes such as scheduling and resource allocation can be shortened. When a coding scheme of the control signaling is the RS coding scheme, the second apparatus may further determine a parameter of the coding scheme of the control signaling based on a size, a format, or a type of the control signaling, to encode the control signaling based on the parameter of the coding scheme of the control signaling, for example, generate a code block based on the control signaling and the parameter (for example, a mother code and a truncation mode) of the coding scheme of the control signaling, to generate the encoded control signaling.

Step 902: The first apparatus receives the control signaling sent by the second apparatus, and decodes the control signaling according to the coding scheme of the control signaling.

For example, the control signaling may be any type of control signaling in this application. This is not limited herein.

The coding scheme of the control signaling may be preconfigured. In a possible implementation, to reduce complexity caused by setting a plurality of coding schemes, the coding scheme of the control signaling may be set to be the same as the coding scheme of the transmitted data, to reduce complexity of determining the coding scheme by the second apparatus and performing decoding according to the coding scheme.

When the coding scheme of the control signaling is the RS coding scheme, the first apparatus may further determine a parameter of the coding scheme of the control signaling based on the size, the format, or the type of the control signaling, to decode the control signaling based on the parameter of the coding scheme of the control signaling, for example, decode a code block based on the control signaling and the parameter (for example, a mother code and a truncation mode) of the coding scheme of the control signaling, to generate the decoded control signaling.

With reference to the accompanying drawings, the following describes apparatuses configured to implement the foregoing methods in embodiments of this application. Therefore, all the foregoing content may be used in the following embodiments. Repeated content is not described again.

FIG. 10 is a schematic block diagram of a first communications apparatus 1000 according to an embodiment of this application.

The first communications apparatus 1000 includes a processing module 1010 and a transceiver module 1020. For example, the first communications apparatus 1000 may be a vehicle-mounted device, or may be a chip used in the vehicle-mounted device, or another combined device, a component, or the like that has a function of the vehicle-mounted device. When the first communications apparatus 1000 is the vehicle-mounted device, the transceiver module 1020 may be a transceiver, and the transceiver may include an antenna, a radio frequency circuit, and the like. The processing module 1010 may be a processor, for example, a baseband processor, and the baseband processor may include one or more central processing units (central processing unit, CPU). When the first communications apparatus 1000 is the component that has a function of the vehicle-mounted device, the transceiver module 1020 may be a radio frequency unit, and the processing module 1010 may be a processor, for example, a baseband processor. When the first communications apparatus 1000 is the chip system, the transceiver module 1020 may be an input/output interface of the chip (for example, a baseband chip), and the processing module 1010 may be a processor of the chip system, and may include one or more central processing units. It should be understood that, in this embodiment of this application, the processing module 1010 may be implemented by a processor or a processor-related circuit component, and the transceiver module 1020 may be implemented by a transceiver or a transceiver-related circuit component.

For example, the processing module 1010 may be configured to perform all operations other than receiving and sending operations performed by the first apparatus or the second apparatus in the embodiment shown in FIG. 2 or FIG. 5, for example, step 201, step 203, step 501, and step 503, for example, operations such as encoding the first data and encoding the second data, and/or configured to support another process of the technology described in this specification. The transceiver module 1020 may be configured to perform all the receiving and sending operations performed by the first apparatus or the second apparatus in the embodiment shown in FIG. 2 or FIG. 5, and/or configured to support another process of the technology described in this specification.

In addition, the transceiver module 1020 may be one functional module. The functional module can implement both a sending operation and a receiving operation. For example, the transceiver module 1020 may be configured to perform all sending operations and receiving operations performed by the first apparatus in the embodiment shown in FIG. 5 or FIG. 2. For example, when a sending operation is performed, it may be considered that the transceiver module 1020 is a sending module, and when a receiving operation is performed, it may be considered that the transceiver module 1020 is a receiving module. Alternatively, the transceiver module 1020 may be two functional modules, and the transceiver module 1020 may be a general term of the two functional modules. The two functional modules are a sending module and a receiving module. The sending module is configured to implement a sending operation. For example, the sending module may be configured to perform all sending operations performed by the first apparatus or the second apparatus in the embodiment shown in FIG. 5 or FIG. 2. The receiving module is configured to implement a receiving operation. For example, the receiving module may be configured to perform all receiving operations performed by the first apparatus or the second apparatus in the embodiment shown in FIG. 5 or FIG. 2.

The processing module 1010 is configured to: encode first data according to a first coding scheme, and send the encoded first data through the transceiver module 1020; and encode second data according to a second coding scheme, and send the encoded second data through the transceiver module, where the first data is different from the second data, and the second coding scheme is different from the first coding scheme.

In a possible implementation, the first coding scheme is an RS coding scheme.

In a possible implementation, the second coding scheme is a polar (polar) coding scheme.

In a possible implementation, that the first data is different from the second data includes at least one of the following:
a service type of the second data is different from a service type of the first data;
a priority of the second data is different from a priority of the first data; and
a transmission mode of the first data is different from a transmission mode of the first data.

In a possible implementation, the first data is noise reduction service data, or the first data contains noise reduction service data, or the first data includes noise reduction service data.

In a possible implementation, the second data is multimedia service data, or the second data contains multimedia service data, or the second data includes multimedia service data.

In a possible implementation, the communications apparatus is a master node. The processing module 1010 is further configured to send scheduling signaling through the transceiver module 1020, where the scheduling signaling is used to determine at least one of the following: a coding scheme of the first data is the first coding scheme, and a coding scheme of the second data is the second coding scheme.

In a possible implementation, the communications apparatus is a master node. The processing module 1010 is further configured to receive transmission request signaling through the transceiver module 1020, where the transmission request signaling is used to determine at least one of the following: the coding scheme of the first data is the first coding scheme, and the coding scheme of the second data is the second coding scheme.

In a possible implementation, the communications apparatus is a slave node. The processing module 1010 is further configured to receive scheduling signaling through the transceiver module 1020, where the scheduling signaling is used to determine at least one of the following: the coding scheme of the first data is the first coding scheme, and the coding scheme of the second data is the second coding scheme.

In a possible implementation, the communications apparatus is a slave node. The processing module 1010 is further configured to send transmission request signaling through the transceiver module 1020, where the transmission request signaling is used to determine at least one of the following: the coding scheme of the first data is the first coding scheme, and the coding scheme of the second data is the second coding scheme.

In a possible implementation, the scheduling signaling includes a first field, and the first field is used to determine at least one of the following: the coding scheme of the first data or the coding scheme of the second data.

In a possible implementation, the first field is used to indicate at least one of the following: the first coding scheme, the priority of the first data, the service type of the first data, or the transmission mode of the first data; and the second coding scheme, the priority of the second data, the service type of the second data, or the transmission mode of the second data.

In a possible implementation, the transmission request signaling includes a second field, and the second field is used to determine at least one of the following: the coding scheme of the first data or the coding scheme of the second data.

In a possible implementation, the second field is used to indicate at least one of the following: the first coding scheme, the priority of the first data, the service type of the first data, or the transmission mode of the first data; and the second coding scheme, the priority of the second data, the service type of the second data, or the transmission mode of the second data.

In a possible implementation, the processing module 1010 is further configured to determine a coding parameter of the RS coding based on a size of a data packet carrying the first data.

In a possible implementation, the processing module 1010 is further configured to send or receive control signaling through the transceiver module 1020, where a coding scheme of the control signaling is the first coding scheme, and the control signaling includes at least one of the following: physical layer signaling and higher layer signaling.

In a possible implementation, the coding scheme of the control signaling includes a parameter of the coding scheme of the control signaling, and the parameter of the coding scheme of the control signaling is determined based on at least one of the following: a size, a format, or a type of the control signaling.

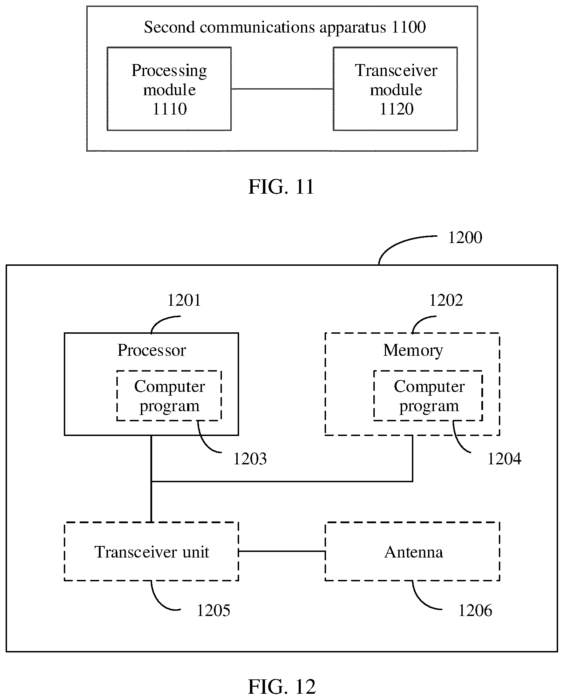

FIG. 11 is a schematic block diagram of a second communications apparatus 1100 according to an embodiment of this application.

The second communications apparatus 1100 includes a processing module 1110 and a transceiver module 1120. For example, the second communications apparatus 1100 may be a vehicle-mounted device, or may be a chip used in the vehicle-mounted device, or another combined device, a component, or the like that has a function of the vehicle-mounted device. When the second communications apparatus 1100 is the vehicle-mounted device, the transceiver module 1120 may be a transceiver, and the transceiver may include an antenna, a radio frequency circuit, and the like. The processing module 1110 may be a processor, for example, a baseband processor, and the baseband processor may include one or more CPUs. When the second communications apparatus 1100 is the component that has a function of the vehicle-mounted device, the transceiver module 1120 may be a radio frequency unit, and the processing module 1110 may be a processor, for example, a baseband processor. When the second communications apparatus 1100 is the chip system, the transceiver module 1120 may be an input/output interface of the chip (for example, a baseband chip), and the processing module 1110 may be a processor of the chip system, and may include one or more central processing units. It should be understood that, in this embodiment of this application, the processing module 1110 may be implemented by a processor or a processor-related circuit component, and the transceiver module 1120 may be implemented by a transceiver or a transceiver-related circuit component.

For example, the processing module 1110 may be configured to perform all operations other than receiving and sending operations performed by the second apparatus or the first apparatus in the embodiment shown in FIG. 2 or FIG. 5, for example, step 205, step 206, step 505, and step 506, and/or configured to support another process of the technology described in this specification. The transceiver module 1120 may be configured to perform all the receiving and sending operations performed by the second apparatus or the first apparatus in the embodiment shown in FIG. 2 or FIG. 5, and/or configured to support another process of the technology described in this specification.

In addition, for an implementation of the transceiver module 1120, refer to the descriptions of the implementation of the transceiver module 1020.

The processing module 1110 is configured to: receive data through the transceiver module 1120; and decode the data according to a first coding scheme, where the first coding scheme is one of at least two coding schemes.

In a possible implementation, the first coding scheme is an RS coding scheme.

In a possible implementation, the second coding scheme is a polar coding scheme.

In a possible implementation, the data is noise reduction service data or multimedia service data; or the data contains at least one of the following: noise reduction service data or multimedia service data; or the data includes at least one of the following: noise reduction service data or multimedia service data.

In a possible implementation, the processing module 1110 is configured to decode the data according to a second coding scheme, where the second coding scheme is different from the first coding scheme.

In a possible implementation, the communications apparatus is a master node. The processing module 1110 is further configured to send scheduling signaling through the transceiver module 1120; and decode the data according to a coding scheme that is of the data and that is determined based on the scheduling signaling. The scheduling signaling is used to determine that the coding scheme of the data is the first coding scheme or the coding scheme of the data is the second coding scheme.

In a possible implementation, the communications apparatus is a master node. The processing module 1110 is further configured to receive transmission request signaling through the transceiver module 1120, where the transmission request signaling is used to determine that the coding scheme of the data is the first coding scheme or the coding scheme of the data is the second coding scheme.

In a possible implementation, the communications apparatus is a slave node. The processing module 1110 is further configured to: receive scheduling signaling through the transceiver module 1120; and decode the data according to the coding scheme that is of the data and that is determined based on the scheduling signaling, where the scheduling signaling is used to determine that the coding scheme of the data is the first coding scheme or the coding scheme of the data is the second coding scheme; and decode the data according to the first coding scheme determined based on the scheduling signaling.

In a possible implementation, the communications apparatus is a slave node. The processing module 1110 is further configured to send transmission request signaling through the transceiver module 1120, where the transmission request signaling is used to determine that the coding scheme of the data is the first coding scheme or the coding scheme of the data is the second coding scheme.

In a possible implementation, the scheduling signaling includes a first field, and the first field is used to determine that the coding scheme of the data is the first coding scheme or the coding scheme of the data is the second coding scheme.

In a possible implementation, the transmission request signaling includes a second field, and the second field is used to determine the coding scheme of the data, or that the coding scheme of the data is the second coding scheme.

In a possible implementation, the first field is used to indicate at least one of the following: the coding scheme of the data, a priority of the data, a service type of the data, or a transmission mode of the data; or
the second field is used to indicate at least one of the following: the coding scheme of the data, a priority of the data, a service type of the data, or a transmission mode of the data.

In a possible implementation, the processing module 1110 is further configured to determine a coding parameter of the first coding scheme based on a size of a data packet carrying the data.

In a possible implementation, the processing module 1110 is further configured to send or receive control signaling through the transceiver module 1120, where a coding scheme of the control signaling is the first coding scheme, and the control signaling includes at least one of the following: physical layer signaling and higher layer signaling.

In a possible implementation, the coding scheme of the control signaling includes a parameter of the coding scheme of the control signaling, and the parameter of the coding scheme of the control signaling is determined based on at least one of the following: a size, a format, or a type of the control signaling.

For other functions that can be implemented by the second communications apparatus 1100, refer to related descriptions in the embodiment shown in FIG. 2 or FIG. 5. Details are not described again.

An embodiment of this application further provides a communications apparatus. The communications apparatus may be a network device, a terminal device, a circuit, or a vehicle-mounted device. The communications apparatus may be configured to perform an action performed by the first apparatus or the second apparatus in the foregoing method embodiments.

Based on a same concept as the foregoing communications methods, as shown in FIG. 12, an embodiment of this application further provides a communications apparatus 1200. The communications apparatus 1200 may be configured to implement the method performed by the first apparatus or the second apparatus in the foregoing method embodiments. For details, refer to the descriptions in the foregoing method embodiments. The communications apparatus 1200 may be a network device, a terminal device, or a vehicle-mounted device, or may be located in a network device, a terminal device, or a vehicle-mounted device, and may be a transmit-end device or a receive-end device.

The communications apparatus 1200 includes one or more processors 1201. The processor 1201 may be a general-purpose processor, a dedicated processor, or the like. For example, the processor may be a baseband processor or a central processing unit. The baseband processor may be configured to process a communications protocol and communication data. The central processing unit may be configured to control a communications apparatus (for example, a network device, a terminal device, a vehicle-mounted device, or a chip), execute a software program, and process data of the software program. The communications apparatus 1200 may include a transceiver unit, configured to input (receive) and output (send) a signal. For example, the transceiver unit may be a transceiver, a radio frequency chip, or the like.

The communications apparatus 1200 includes one or more processors 1201. The one or more processors 1201 may implement the method performed by the first apparatus or the second apparatus in the foregoing embodiments.

Optionally, the processor 1201 may further implement another function in addition to the methods in the foregoing embodiments. Optionally, in an implementation, the processor 1201 may execute a computer program, so that the communications apparatus 1200 performs the method performed by the first apparatus or the second apparatus in the foregoing method embodiments. All or a part of the computer program may be stored in the processor 1201, for example, a computer program 1203. Alternatively, all or a part of the computer program may be stored in the memory 1202 coupled to the processor 1201, for example, a computer program 904. Alternatively, the computer programs 1203 and 904 may be used together to enable the communications apparatus 1200 to perform the method performed by the first apparatus or the second apparatus in the foregoing method embodiments.

In still another possible implementation, the communications apparatus 1200 may alternatively include a circuit, and the circuit may implement functions performed by the first apparatus or the second apparatus in the foregoing method embodiments.

In still another possible implementation, the communications apparatus 1200 may include one or more memories 1202 that store a computer program 1204. The computer program may be run on a processor, so that the communications apparatus 1200 performs the communications method described in the foregoing method embodiments. Optionally, the memory may further store data. Optionally, the processor may also store a computer program and/or data. For example, the one or more memories 1202 may store an association or a correspondence described in the foregoing embodiments, or a related parameter or table provided in the foregoing embodiments. The processor and the memory may be disposed separately, or may be integrated or coupled together.

In still another possible implementation, the communications apparatus 1200 may further include a transceiver unit 1205. The processor 1201 may be referred to as a processing unit, and controls a communications apparatus (the first communications apparatus or the second communications apparatus). The transceiver unit 1205 may be referred to as a transceiver, a transceiver circuit, or the like, and is configured to receive and send data or control signaling.

For example, if the communications apparatus 1200 is a chip used in a communications device or another combined device, component, or the like that has a function of the communications device, the communications apparatus 1200 may include the transceiver unit 1205.

In still another possible implementation, the communications apparatus 1200 may further include a transceiver unit 1205 and an antenna 1206. The processor 1201 may be referred to as a processing unit, and controls a communications apparatus (the first communications apparatus or the second communications apparatus). The transceiver unit 1205 may be referred to as a transceiver, a transceiver circuit, or the like, and is configured to implement sending and receiving functions of the apparatus by using the antenna 1206.

It should be noted that, the processor in embodiments of this application may be an integrated circuit chip, and has a signal processing capability. In an implementation process, the steps in the foregoing method embodiments may be completed by using an integrated logic circuit of hardware in the processor, or a computer program in a form of software. The foregoing processor may be a general purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or transistor logic device, or a discrete hardware component. The processor may implement or perform the methods, steps, and logical block diagrams that are disclosed in embodiments of this application. The general-purpose processor may be a microprocessor, or the processor may be any conventional processor or the like. The steps of the methods disclosed with reference to embodiments of this application may be directly performed and completed by a hardware decoding processor, or may be performed and completed by using a combination of hardware and software modules in the decoding processor. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

It may be understood that the memory in this embodiment of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM). It should be noted that the memory of the systems and methods described in this specification includes but is not limited to these and any memory of another proper type.

An embodiment of this application further provides a computer-readable storage medium that stores a computer program. When the computer program is executed by a computer, the method performed by the first apparatus or the second apparatus described in any one of the foregoing method embodiments is implemented.

An embodiment of this application further provides a computer program product. When the computer program product is executed by a computer, the method performed by the first apparatus or the second apparatus in any one of the foregoing method embodiments is implemented.

All or some of the foregoing embodiments may be implemented by using software, hardware, firmware, or any combination thereof. When software is used to implement embodiments, all or a part of the embodiments may be implemented in a form of a computer program product. The computer program product includes one or more computer programs. When the computer programs are loaded and executed on a computer, all or some of the procedure or functions according to embodiments of this application are generated. The computer may be a general-purpose computer, a dedicated computer, a computer network, or other programmable apparatuses. The computer program may be stored in a computer-readable storage medium or may be transmitted from a computer-readable storage medium to another computer-readable storage medium. For example, the computer program may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a high-density digital video disc (digital video disc, DVD)), a semiconductor medium (for example, a solid state disk (solid state disk, SSD)), or the like.

An embodiment of this application further provides a communications apparatus, including a processor and an interface. The processor is configured to perform the method performed by the first apparatus or the second apparatus in any one of the foregoing method embodiments.

It should be understood that the foregoing processing apparatus may be a chip. The processor may be implemented by using hardware, or may be implemented by using software. When the processor is implemented by using the hardware, the processor may be a logic circuit, an integrated circuit, or the like; or when the processor is implemented by using the software, the processor may be a general-purpose processor, and is implemented by reading software code stored in a memory. The memory may be integrated into the processor, or may be located outside the processor and exist independently.

An embodiment of this application further provides a communications system. The communications system may include the first apparatus and the second apparatus in the embodiment shown in FIG. 2 or FIG. 5. During downlink transmission, the first apparatus is, for example, the first communications apparatus 1000 in FIG. 10, and the second apparatus is, for example, the second communications apparatus 1100 in FIG. 11. During uplink transmission, the second apparatus is, for example, the first communications apparatus 1000 in FIG. 10, and the first apparatus is, for example, the second communications apparatus 1100 in FIG. 11.

An embodiment of this application further provides a computer-readable storage medium. The computer-readable storage medium stores a computer program. When the computer program is executed by a computer, the computer may implement a procedure related to the first apparatus or the second apparatus in the method embodiment shown in FIG. 2 or FIG. 5 provided in the method embodiments.

An embodiment of this application further provides a computer program product. The computer program product is configured to store a computer program. When the computer program is executed by a computer, the computer may implement a procedure related to the first apparatus or the second apparatus in the embodiment shown in FIG. 5 provided in the method embodiments.

It should be understood that the processor in embodiments of this application may be a CPU, or may be another general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or a transistor logic device, a discrete hardware component, or the like. The general purpose processor may be a microprocessor, or the processor may be any conventional processor or the like.

It may be further understood that the memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM).

It should be noted that when the processor is a general purpose processor, a DSP, an ASIC, an FPGA or another programmable logic device, a discrete gate, a transistor logic device, or a discrete hardware component, the memory (a storage module) is integrated into the processor.

It should be noted that the memory described in this specification includes but is not limited to these memories and any memory of another proper type.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiment. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected according to actual requirements to achieve the objectives of the solutions of the embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on this understanding, the technical solutions of this application essentially, or the part contributing to the conventional technology, or some of the technical solutions may be implemented in a form of a software product. The computer software product is stored in a storage medium, and includes several instructions for instructing a computer device (which may be, for example, a personal computer, a server, or a network device) to perform all or some of the steps of the methods described in embodiments of this application. The foregoing computer-readable storage medium may be any usable medium accessible by the computer. By way of example but not limitation, the computer-readable medium may include a random access memory (random access memory, RAM), a read-only memory (read-only memory, ROM), an electrically erasable programmable read-only memory (electrically erasable programmable read only memory, EEPROM), a compact disc read-only memory (compact disc read-only memory, CD-ROM), a universal serial bus flash disk (universal serial bus flash disk), a removable hard disk or another compact disc storage, a magnetic disk storage medium or another magnetic storage device, or any other medium that can be used to carry or store expected program code in a form of an instruction or a data structure and that can be accessed by a computer.

The foregoing descriptions are merely specific implementations of this application, but are not intended to limit the protection scope of embodiments of this application. Any variation or replacement readily figured out by a person skilled in the art within the technical scope disclosed in embodiments of this application shall fall within the protection scope of embodiments of this application. Therefore, the protection scope of embodiments of this application shall be subject to the protection scope of the claims.

## Claims

1. A communications method, comprising:
encoding first data according to a first coding scheme;
sending the encoded first data;
encoding second data according to a second coding scheme, wherein the first data is different from the second data, and the second coding scheme is different from the first coding scheme; and
sending the encoded second data.

2. The method according to claim 1, wherein the first coding scheme is a Reed-Solomon RS coding scheme.

3. The method according to claim 1 or 2, wherein that the first data is different from the second data comprises at least one of the following:
a service type of the second data is different from a service type of the first data;
a priority of the second data is different from a priority of the first data; and
a transmission mode of the first data is different from a transmission mode of the first data.

4. The method according to any one of claims 1 to 3, wherein the communications method is performed by a master node, and the method further comprises:
sending scheduling signaling, wherein the scheduling signaling is used to determine at least one of the following:
a coding scheme of the first data is the first coding scheme; and
a coding scheme of the second data is the second coding scheme.

5. The method according to any one of claims 1 to 4, wherein the communications method is performed by a master node, and the method further comprises:
receiving transmission request signaling, wherein the transmission request signaling is used to determine at least one of the following:
the coding scheme of the first data is the first coding scheme; and
the coding scheme of the second data is the second coding scheme.

6. The method according to any one of claims 1 to 5, wherein the communications method is performed by a slave node, and the method further comprises:
receiving scheduling signaling, wherein the scheduling signaling is used to determine at least one of the following:
the coding scheme of the first data is the first coding scheme; and
the coding scheme of the second data is the second coding scheme.

7. The method according to any one of claims 1 to 6, wherein the communications method is performed by a slave node, and the method further comprises:
sending transmission request signaling, wherein the transmission request signaling is used to determine at least one of the following:
the coding scheme of the first data is the first coding scheme; and
the coding scheme of the second data is the second coding scheme.

8. The method according to claim 4 or 6, wherein the scheduling signaling comprises a first field; and
the first field is used to determine at least one of the following: the coding scheme of the first data or the coding scheme of the second data.

9. The method according to claim 8, wherein the first field is used to indicate at least one of the following:
the first coding scheme, the priority of the first data, the service type of the first data, or the transmission mode of the first data; and the second coding scheme, the priority of the second data, the service type of the second data, or the transmission mode of the second data.

10. The method according to claim 5 or 7, wherein the transmission request signaling comprises a second field, and the second field is used to determine at least one of the following: the coding scheme of the first data or the coding scheme of the second data.

11. The method according to claim 10, wherein the second field is used to indicate at least one of the following:
the first coding scheme, the priority of the first data, the service type of the first data, or the transmission mode of the first data; and the second coding scheme, the priority of the second data, the service type of the second data, or the transmission mode of the second data.

12. The method according to any one of claims 1 to 11, wherein the method further comprises:
determining a coding parameter of the RS coding based on a size of a data packet carrying the first data.

13. The method according to any one of claims 1 to 12, wherein the method comprises:
sending or receiving control signaling, wherein a coding scheme of the control signaling is the first coding scheme, and the control signaling comprises at least one of the following: physical layer signaling and higher layer signaling.

14. The method according to claim 13, wherein the coding scheme of the control signaling comprises a parameter of the coding scheme of the control signaling; and
the parameter of the coding scheme of the control signaling is determined based on at least one of the following: a size, a format, or a type of the control signaling.

15. A communications method, comprising:
receiving data; and
decoding the data according to a first coding scheme, wherein the first coding scheme is one of at least two coding schemes.

16. The method according to claim 15, wherein the first coding scheme is a Reed-Solomon RS coding scheme.

17. The method according to claim 15 or 16, wherein the method further comprises:
decoding the data according to a second coding scheme, wherein the second coding scheme is different from the first coding scheme.

18. The method according to any one of claims 15 to 17, wherein the communications method is performed by a master node, and the method further comprises:
sending scheduling signaling, wherein the scheduling signaling is used to determine that a coding scheme of the data is the first coding scheme or a coding scheme of the data is the second coding scheme.

19. The method according to any one of claims 15 to 18, wherein the communications method is performed by a master node, and the method further comprises:
receiving transmission request signaling, wherein the transmission request signaling is used to determine that the coding scheme of the data is the first coding scheme or the coding scheme of the data is the second coding scheme.

20. The method according to any one of claims 15 to 19, wherein the communications method is performed by a slave node, and the method further comprises:
receiving scheduling signaling, wherein the scheduling signaling is used to determine that the coding scheme of the data is the first coding scheme or the coding scheme of the data is the second coding scheme; and
decoding the data according to the coding scheme that is of the data and that is determined based on the scheduling signaling.

21. The method according to any one of claims 15 to 20, wherein the communications method is performed by a slave node, and the method further comprises:
sending transmission request signaling, wherein the transmission request signaling is used to determine that the coding scheme of the data is the first coding scheme or the coding scheme of the data is the second coding scheme.

22. The method according to claim 18 or 20, wherein the scheduling signaling comprises a first field, and the first field is used to determine that the coding scheme of the data is the first coding scheme or the coding scheme of the data is the second coding scheme.

23. The method according to claim 19 or 21, wherein the transmission request signaling comprises a second field, and the second field is used to determine the coding scheme of the data, or that the coding scheme of the data is the second coding scheme.

24. The method according to claim 22 or 23, wherein the first field is used to indicate at least one of the following: the coding scheme of the data, a priority of the data, a service type of the data, or a transmission mode of the data; or
the second field is used to indicate at least one of the following: the coding scheme of the data, a priority of the data, a service type of the data, or a transmission mode of the data.

25. The method according to any one of claims 15 to 24, wherein the method further comprises:
determining a coding parameter of the first coding scheme based on a size of a data packet carrying the data.

26. The method according to any one of claims 15 to 25, wherein the method comprises:
sending or receiving control signaling, wherein a coding scheme of the control signaling is the first coding scheme, and the control signaling comprises at least one of the following: physical layer signaling and higher layer signaling.

27. The method according to claim 26, wherein the coding scheme of the control signaling comprises a parameter of the coding scheme of the control signaling; and
the parameter of the coding scheme of the control signaling is determined based on at least one of the following: a size, a format, or a type of the control signaling.

28. A communications apparatus, comprising a transceiver module and a processing module, wherein
the processing module is configured to: encode first data according to a first coding scheme; encode second data according to a second coding scheme, wherein the first data is different from the second data, and the second coding scheme is different from the first coding scheme; send the encoded first data through the transceiver module; and send the encoded second data through the transceiver module.

29. The apparatus according to claim 28, wherein the first coding scheme is a Reed-Solomon RS coding scheme.

30. The apparatus according to claim 28 or 29, wherein that the first data is different from the second data comprises at least one of the following:
a service type of the second data is different from a service type of the first data;
a priority of the second data is different from a priority of the first data; and
a transmission mode of the first data is different from a transmission mode of the first data.

31. The apparatus according to any one of claims 28 to 30, wherein the communications apparatus is a master node, and the processing module is further configured to send scheduling signaling through the transceiver module, wherein the scheduling signaling is used to determine at least one of the following:
a coding scheme of the first data is the first coding scheme; and
a coding scheme of the second data is the second coding scheme.

32. The apparatus according to any one of claims 28 to 31, wherein the communications apparatus is a master node, and the processing module is further configured to receive transmission request signaling through the transceiver module, wherein the transmission request signaling is used to determine at least one of the following:
the coding scheme of the first data is the first coding scheme; and
the coding scheme of the second data is the second coding scheme.

33. The apparatus according to any one of claims 28 to 32, wherein the communications apparatus is a slave node, and the processing module is further configured to receive scheduling signaling through the transceiver module, wherein the scheduling signaling is used to determine at least one of the following: the coding scheme of the first data is the first coding scheme; and
the coding scheme of the second data is the second coding scheme.

34. The apparatus according to any one of claims 28 to 33, wherein the communications apparatus is a slave node, and the processing module is further configured to send transmission request signaling through the transceiver module, wherein the transmission request signaling is used to determine at least one of the following:
the coding scheme of the first data is the first coding scheme; and
the coding scheme of the second data is the second coding scheme.

35. The apparatus according to claim 31 or 33, wherein the scheduling signaling comprises a first field, and the first field is used to determine at least one of the following: the coding scheme of the first data or the coding scheme of the second data.

36. The apparatus according to claim 35, wherein the first field is used to indicate at least one of the following:
the first coding scheme, the priority of the first data, the service type of the first data, or the transmission mode of the first data; and the second coding scheme, the priority of the second data, the service type of the second data, or the transmission mode of the second data.

37. The apparatus according to claim 32 or 34, wherein the transmission request signaling comprises a second field, and the second field is used to determine at least one of the following: the coding scheme of the first data or the coding scheme of the second data.

38. The apparatus according to claim 37, wherein the second field is used to indicate at least one of the following: the first coding scheme, the priority of the first data, the service type of the first data, or the transmission mode of the first data; and the second coding scheme, the priority of the second data, the service type of the second data, or the transmission mode of the second data.

39. The apparatus according to any one of claims 28 to 38, wherein the processing module is further configured to determine a coding parameter of the RS coding based on a size of a data packet carrying the first data.

40. The apparatus according to any one of claims 28 to 39, wherein the processing module is further configured to send or receive control signaling through the transceiver module, wherein a coding scheme of the control signaling is the first coding scheme, and the control signaling comprises at least one of the following: physical layer signaling and higher layer signaling.

41. The apparatus according to claim 40, wherein the coding scheme of the control signaling comprises a parameter of the coding scheme of the control signaling; and
the parameter of the coding scheme of the control signaling is determined based on at least one of the following: a size, a format, or a type of the control signaling.

42. A communications apparatus, comprising a transceiver module and a processing module, wherein
the processing module is configured to: receive data through the transceiver module; and decode the data according to a first coding scheme, wherein the first coding scheme is one of at least two coding schemes.

43. The apparatus according to claim 42, wherein the first coding scheme is a Reed-Solomon RS coding scheme.

44. The apparatus according to claim 42 or 43, wherein the processing module is further configured to decode the data according to a second coding scheme, wherein the second coding scheme is different from the first coding scheme.

45. The apparatus according to any one of claims 42 to 44, wherein the communications apparatus is a master node, and the processing module is further configured to send scheduling signaling through the transceiver module, wherein the scheduling signaling is used to determine that a coding scheme of the data is the first coding scheme or a coding scheme of the data is the second coding scheme.

46. The apparatus according to any one of claims 42 to 45, wherein the communications apparatus is a master node, and the processing module is further configured to: receive transmission request signaling through the transceiver module; and decode the data according to a coding scheme that is of the data and that is determined based on the scheduling signaling, wherein the transmission request signaling is used to determine that the coding scheme of the data is the first coding scheme or the coding scheme of the data is the second coding scheme.

47. The apparatus according to any one of claims 42 to 46, wherein the communications apparatus is a slave node, and the processing module is further configured to: receive scheduling signaling through the transceiver module, wherein the scheduling signaling is used to determine that the coding scheme of the data is the first coding scheme or the coding scheme of the data is the second coding scheme; and
decode the data according to the first coding scheme determined based on the scheduling signaling.

48. The apparatus according to any one of claims 42 to 47, wherein the communications apparatus is a slave node, and the processing module is further configured to send transmission request signaling through the transceiver module, wherein the transmission request signaling is used to determine that the coding scheme of the data is the first coding scheme or the coding scheme of the data is the second coding scheme.

49. The apparatus according to claim 45 or 47, wherein the scheduling signaling comprises a first field, and the first field is used to determine that the coding scheme of the data is the first coding scheme or the coding scheme of the data is the second coding scheme.

50. The apparatus according to claim 46 or 48, wherein the transmission request signaling comprises a second field, and the second field is used to determine the coding scheme of the data, or that the coding scheme of the data is the second coding scheme.

51. The apparatus according to claim 49 or 50, wherein the first field is used to indicate at least one of the following: the coding scheme of the data, a priority of the data, a service type of the data, or a transmission mode of the data; or
the second field is used to indicate at least one of the following: the coding scheme of the data, a priority of the data, a service type of the data, or a transmission mode of the data.

52. The apparatus according to any one of claims 42 to 51, wherein the processing module is further configured to determine a coding parameter of the first coding scheme based on a size of a data packet carrying the data.

53. The apparatus according to any one of claims 42 to 52, wherein the processing module is further configured to send or receive control signaling through the transceiver module, wherein a coding scheme of the control signaling is the first coding scheme, and the control signaling comprises at least one of the following: physical layer signaling and higher layer signaling.

54. The apparatus according to claim 53, wherein the coding scheme of the control signaling comprises a parameter of the coding scheme of the control signaling; and
the parameter of the coding scheme of the control signaling is determined based on at least one of the following: a size, a format, or a type of the control signaling.

55. A communications apparatus, comprising a processor, wherein the processor is coupled to at least one memory, and the processor is configured to read a computer program stored in the at least one memory, to perform the method according to any one of claims 1 to 14 or the method according to any one of claims 15 to 27.

56. A computer-readable storage medium, comprising a computer program, wherein when the computer program is run on a computer, the computer is enabled to perform the method according to any one of claims 1 to 27.

57. A computer program product, wherein when the computer program product is run on a processor, an apparatus is enabled to perform the method according to any one of claims 1 to 27.

58. A chip, comprising a processor and a communications interface, wherein the processor is configured to read instructions to perform the method according to any one of claims 1 to 14 or the method according to any one of claims 15 to 27.

59. A communications system, comprising the apparatus according to any one of claims 28 to 41 and the apparatus according to any one of claims 42 to 54.
